(19) Europäisches Patentamt
European Patent Office
Office européen des brevets

(11) EP 1 629 975 B1

(12) # EUROPEAN PATENT SPECIFICATION

(45) Date of publication and mention of the grant of the patent:
**02.01.2008 Bulletin 2008/01**

(51) Int Cl.:
***B41C 1/10*** *(2006.01)*

(21) Application number: **05017854.0**

(22) Date of filing: **17.08.2005**

(54) **Planographic printing plate precursor and method of making planographic printing plate**

Flachdruckplattenvorläufer sowie Verfahren zur Herstellung einer Flachdruckplatte

Précurseur de plaque lithographique et procédé de fabrication de plaque lithographique

(84) Designated Contracting States:
**AT BE BG CH CY CZ DE DK EE ES FI FR GB GR HU IE IS IT LI LT LU LV MC NL PL PT RO SE SI SK TR**

(30) Priority: **27.08.2004 JP 2004248535**

(43) Date of publication of application:
**01.03.2006 Bulletin 2006/09**

(73) Proprietor: **FUJIFILM Corporation**
**Minato-ku**
**Tokyo (JP)**

(72) Inventor: **Goto, Takahiro**
**Yoshida-cho**
**Haibara-gun**
**Shizuoka-ken (JP)**

(74) Representative: **HOFFMANN EITLE**
**Patent- und Rechtsanwälte**
**Arabellastrasse 4**
**81925 München (DE)**

(56) References cited:
**EP-A- 1 176 467**
**EP-A- 1 223 196**
**JP-A- 11 038 633**
**US-B1- 6 294 298**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 629 975 B1

## Description

BACKGROUND OF THE INVENTION

Field of the Invention

The present invention relates to a negative type planographic printing plate precursor enabling direct printing using infrared laser light and high-speed printing and to a method of plate-making for the precursor, and, particularly, to a planographic printing plate precursor which is improved in bonding resistance between the surface of the photosensitive layer side of a planographic printing plate precursor and the surface of the support side of a planographic printing plate precursor adjacent thereto when laminated thereupon, and also to a method of plate-making the precursor.

Description of the Related Art

Conventionally, a plate having a lipophilic photosensitive resin layer provided on a hydrophilic support has been used widely as a planographic printing plate precursor, and a desired printing plate is obtained by a plate-making method which usually involves masked light exposure (surface light exposure) via a lithographic film and then removing a non-image area by dissolution. In recent years, digitalization techniques which involve electronic processing, accumulation and output of image information with a computer are spreading. A wide variety of new image output systems compatible with these digitalization techniques have come to be used in practice. As a result, there has been demand for computer-to-plate (CTP) techniques for producing a printing plate directly by scanning a highly directional light such as a laser light according to digitalized image information without a lithographic film, and the provision of a planographic printing plate precursor adapted to these techniques has proved a significant technical challenge.

As a planographic printing plate precursor capable of such scanning exposure, a planographic printing plate precursor comprising a hydrophilic support provided thereon with a lipophilic photosensitive resin layer (also referred to as the photosensitive layer) containing a photosensitive compound capable of generating active species such as radicals or Bronsted acid upon exposure to a laser light has been proposed and made commercially available. This planographic printing plate precursor is subjected to laser scanning according to digital information to generate active species acting on the photosensitive layer to cause physical or chemical change, thus making the layer insoluble, and then subjected to development treatment to give a negative planographic printing plate. In particular, a planographic printing plate precursor provided with a photopolymerizable type photosensitive layer containing a photopolymerization initiator superior in photosensitive speed, an addition polymerizable ethylenic unsaturated compound and a binder polymer soluble in an alkali developing solution on a hydrophilic support and, as required, a protective layer having oxygen cut-off ability on a hydrophilic support has the advantages of high productivity, simple development treatment and high resolution and print adhesion, which advantages give the planographic printing plate precursor a desirable printing performance (see for example, Japanese Patent Application Laid-Open (JP-A) No. 10-228109).

Also, in order to further improve productivity, a recording material has been disclosed which comprises a cyanine dye having a specific structure, an iodonium salt and an addition polymerizable compound having an ethylenic unsaturated double bond and needs no heating treatment after imagewise exposure (see, for example, Japanese Patent Application Publication (JP-B) No. 7-103171). This image recording material, however, has a drawback in that polymerization inhibition is caused by oxygen in the air in the polymerization reaction, bringing about reduced sensitivity and unsatisfactory strength of the formed image.

To address this problem, the following methods are known: a method in which a protective layer containing a water-soluble polymer is formed on a photosensitive layer and a method in which a protective layer containing an inorganic layered compound and a water-soluble polymer is formed (see, for example, JP-A No. 11-38633). The presence of the protective layer prevents polymerization inhibition so that a curing reaction is promoted at the photosensitive layer and it is therefore possible to improve the strength of the image area.

On the other hand, with regard to productivity in the plate-making operation of a photopolymerization type planographic printing plate precursor featuring simple development treatment, it is important to shorten the time required in the exposure step. In the exposure step, a laminate is usually supplied in which interleaf paper having the function of preventing adhesion between precursors is interposed between these precursors. Thus, the time required to remove the paper in the exposure step poses an inefficiency problem. In order to raise efficiency in this exposure step, it is simply required that a laminate provided with no interleaf paper interposed between the precursors is used to thereby dispense with the step of removing the interleaf paper. Accordingly, improvement of bonding resistance between precursors has been desired.

Also, in the case of using a photopolymerization type planographic printing plate precursor with a protective layer in plate-making operations, the pre-water-washing step for removing the protective layer is a cause of reduced productivity. As a measure to dispense with this step, a planographic printing plate precursor is known in which the film

weight of a protective layer is designed to be from 0.05 $g/m^2$ to 1.0 $g/m^2$ and an acid modified polyvinyl alcohol is preferably used for this protective layer (see, for example, JP-A No. 2004-118070).

This planographic printing plate precursor makes it possible to dispense with the pre-water-washing step. However, no consideration is taken of shortening the time taken to carry out the exposure step as mentioned above.

In EP 1 176 467 A1, a negative working photosensitive lithographic printing plate is disclosed, which comprises a support having thereon at least one photosensitive layer containing a polymeric binder having repeating units represented by formula (I):

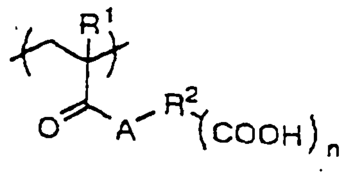

(I)

wherein $R^1$ represents a hydrogen atom or a methyl group; $R^2$ represents a hydrocarbon group which has an alicyclic structure and has 3 to 30 carbon atoms and a valence of n+1; A represents an oxygen atom or $-NR^3-$, wherein $R^3$ represents a hydrogen atom or a monovalent hydrocarbon group having 1 to 10 carbon atoms ; and n is an integer of 1 to 5. The negative working photosensitive lithographic printing plate can attain both high productivity and high printing durability. It is especially suitable for drawing with laser light.

From the above, there has been a desire to develop a planographic printing plate precursor which is provided with a protective layer suppressing polymerization inhibition and is capable of improving productivity in plate-making operations.

## SUMMARY OF THE INVENTION

The present invention has been made in view of the above circumstances and provides a planographic printing plate precursor which is provided with a protective layer and is capable of improving productivity in plate-making operations, and provides a method of making the planographic printing plate precursor.

More specifically, the invention provides a planographic printing plate precursor which permits writing using an infrared laser, prevents polymerization inhibition, has superior developing removability, and is also provided with a protective layer which can improve bonding resistance of the photosensitive layer side surface (the surface of the protective layer) of a planographic printing plate precursor to the support side surface of a planographic printing plate precursor adjacent to the above planographic printing plate precursor when these planographic printing plate precursors are laminated, and also provides a method of plate-making the precursor.

The inventor of the invention has conducted intensive research and, as a result, found that the above can be attained by compounding a mica compound and a specific polyvinyl alcohol in the protective layer, and thus completed the invention.

A first aspect of the invention provides a planographic printing plate precursor comprising a photosensitive layer containing an infrared absorber, a polymerization initiator, a polymerizable compound and a binder polymer, and a protective layer laminated on a support in this order, wherein;
the protective layer contains a mica compound and at least one polyvinyl alcohol selected from the group consisting of a polyvinyl alcohol having a saponification value of 90 mol% or less and an acid modified polyvinyl alcohol.

The phrase "laminated on a support in this order" means that a photosensitive layer and a protective layer are arranged on a support in this order, but this phrase dose not deny the presence of other layers (for example, an intermediate layer, a back coat layer, etc.) arranged in accordance with specific objectives.

A second aspect of the invention provides a method of making a planographic printing plate, the method comprising exposing the planographic printing plate precursor of the first aspect to light having a wavelength of 750 nm to 1400 nm and then carrying out development treatment at a conveying speed of 1.25 m/min. or more with substantially no heat treatment and no water-washing treatment.

Although the mechanism of the invention is not clear, it is presumed as follows.

The protective layer in the invention contains a mica compound and the aforementioned specific polyvinyl alcohol and, therefore, developing removability and film strength are improved and matting characteristics are also developed. It is inferred from the above results that the protective layer can be completely removed in a developing step even if a pre-water-washing step is dispensed with while still suppressing polymerization inhibition and also, when planographic printing plate precursors with this protective layer are laminated, the protective layer constituting the photosensitive layer side surface of the planographic printing plate precursor can be prevented from being stuck to the

support side surface of the adjacent planographic printing plate precursor.

## BRIEF DESCRIPTION OF THE DRAWINGS

Fig. 1 is a schematic diagram showing one example of DRM interference wave measuring instrument for measuring dissolution behavior of a photosensitive layer.
Fig. 2 is schematic diagram showing one example of measuring electrostatic capacity used in evaluating the permeation of a developing solution into the photosensitive layer (recording layer).

## DETAILED DESCRIPTION OF THE INVENTION

< Planographic printing plate precursor >

The planographic printing plate precursor of the present invention will be explained in detail.

The planographic printing plate precursor of the invention includes a photosensitive layer containing an infrared absorber, a polymerization initiator, a polymerizable compound and a binder polymer and a protective layer laminated on a support in this order. The protective layer contains a mica compound and at least one polyvinyl alcohol selected from the group consisting of a polyvinyl alcohol having a saponification value of 90 mol% or less and an acid modified polyvinyl alcohol.

Each structural element constituting the planographic printing plate precursor of the invention will be explained.

[Protective layer]

The protective layer according to the invention contains a mica compound and at least one polyvinyl alcohol selected from the group consisting of a polyvinyl alcohol having a saponification value of 90 mol % or less and an acid modified polyvinyl alcohol (hereinafter, these polyvinyl alcohols are generally referred to as "specified polyvinyl alcohols" as the case may be).

In the planographic printing plate precursor of the invention, the photosensitive layer is a polymerizable negative type photosensitive layer (which will be explained later) and a protective layer is therefore formed usually on the photosensitive layer to prevent contamination of the photosensitive layer with oxygen and moisture existing in the air and low-molecular compounds such as basic materials which inhibit an image formation reaction in the photosensitive layer because an exposure operation is carried out in the air.

The protective layer may be made to contain the aforementioned specific polyvinyl alcohol and mica compound to thereby attain excellent developing removability and film strength, and also to impart matting characteristics to the protective layer. As a result, the protective layer has characteristics that, besides the foregoing the ability to cut off oxygen and the like, the protective layer has the abilities to prevent a deterioration based on deformation and can also be removed in the developing step even if a pre-water-washing step is omitted. Also, the matting characteristics are imparted to the protective layer. Therefore, when the planographic printing plate precursors of the invention are laminated on each other, it is possible to suppress the bond between the photosensitive layer side surface (the surface of the protective layer) of the planographic printing plate precursor and the support side surface of the neighboring planographic printing plate precursor.

The mica compound and the specific polyvinyl alcohol will be explained.

(Mica compound)

Examples of the mica compound used in the invention include micas such as natural micas and synthetic micas represented by the formula $A(B,C)_2\text{-}5D_4O_{10}(OH, F, O)_2$ (wherein A represents any one of K, Na and Ca, B and C each represent any one of Fe(II), Fe(III), Mn, Al, Mg and V and D represents Si or Al).

Among the above micas, examples of the natural micas include muscovite, soda mica, phlogopite, biotite and lepidolite. Also, examples of the synthetic mica include non-swellable micas such as fluorine muscovite ($KMg_3(AlSi_3O_{10})F_2$) and potassium tetrasilicic mica ($KMg_{2.5}(Si_4O_{10})F_2$) and swellable micas such as Na tetrasilicic mica ($NaMg_{2.5}(Si_4O_{10})F_2$), Na or Li teniorite ($(Na, Li)Mg_2Li(Si_4O_{10})F_2$) and montmorillonite type Na or Li hectorite ($(Na, Li)_{1/8}Mg_{2/5}Li_{1/8}(Si_4O_{10})F_2$). In addition, synthetic smectites are also useful.

In the invention, fluorine type swellable micas are particularly useful among the above mica compounds. Specifically, this swellable synthetic mica has a laminated structure comprising a unit crystal lattice layer having a thickness of about 10 to 15Å and the inter-lattice metal atom substitution of this swellable mica is significantly larger than that of

other clay minerals. As a result, the lattice layer lacks in positive charges and therefore positive ions such as $Na^+$, $Ca^{2+}$ and $Mg^{+2}$ are adsorbed to the lattice layers to compensate the lacked charges. These positive ions interposed between these layers are called exchangeable positive ions and are exchanged with various positive ions. When the positive ion between layers is particularly $Li^+$ or $Na^+$, these ions have a small ion diameter so that the bonding strength between layer crystal lattices is weak and the layer largely swells. Shear is applied to this swellable synthetic mica, the mica is easily cleft to form a stable sol in water. This tendency is strengthened in these swellable synthetic micas, which are useful in the invention and particularly swellable synthetic micas are preferably used.

As to the shape of the mica compound used in the invention, the mica compound is preferably thinner from the viewpoint of controlling diffusion and the plane size of the mica compound is preferably larger insofar as the smoothness of the coating surface and the transmittance for active rays are not impaired. Therefore, the aspect ratio of the mica is preferably 20 or more, more preferably 100 or more and particularly preferably 200 or more. It is to be noted that the aspect ratio is the ratio of the major axis of a particle to the thickness of the particle and may be measured from a projected image of a microphotograph of the particles. The larger the aspect ratio is, the larger the obtained effect is.

As to the particle diameter of the mica compound to be used in the invention, the average major particle diameter of the mica is 0.3 to 20μm, preferably 0.5 to 10μm and particularly preferably 1 to 5μm. Also, the average thickness of the particle is 0.1 μm or less, preferably 0.05μm or less and particularly preferably 0.01μm or less. Specifically, the size of, for example, the swellable synthetic mica which is a typical compound is as follows: thickness: 1 to 50 nm and plane size (major axis): about 1 to 20μm.

The amount of the mica compound contained in the protective layer is in a range preferably from 5 to 55% by mass and more preferably from 10 to 40% by mass based on the total solid content of the protective layer. When the amount of the mica compound is less than 5% by mass, the mica compound has no effect of bonding resistance, whereas when the amount of the mica compound exceeds 55% by mass, unsatisfactory film-forming characteristics are obtained, leading to reduced sensitivity.

Also, in the case of using plural types of mica compound are used together, the ratio of the total amount of these mica compounds is preferably in the above range. (Polyvinyl alcohol having a saponification degree of 90 mol% or less and Acid-modified polyvinyl alcohol)

The fundamental characteristics required for the protective layer to be formed on the polymerizable negative type photosensitive layer like the case of the invention are that the protective layer has a low permeability to low-molecular compounds such as oxygen, does not substantially inhibit transmittance for the light used for exposure, is superior in adhesion to the photosensitive layer and can be removed in the developing step after exposed to light.

In order to obtain more excellent developing removability in addition to the fundamental characteristics required for such a protective layer, it is preferable to use at least one polyvinyl alcohol selected from the group consisting of polyvinyl alcohols having a saponification value of 90 mol% or less and acid-modified polyvinyl alcohols as the binder component of the protective layer.

All these specific polyvinyl alcohols have the characteristics such as excellent film-forming characteristics and high solubility in a developing solution.

- Polyvinyl alcohol having a saponification value of 90 mol% or less -

The polyvinyl alcohol used in the invention and having a saponification value of 90 mol% or less may be substituted in part with an ester, ether and acetal insofar as it contains an unsubstituted vinyl alcohol unit necessary to provide oxygen-cutting ability and water-solubility. Also, a part of the polyvinyl alcohol may likewise have other copolymerization components.

Generally, a PVA has the characteristics that as the saponification value of the PVA to be used is decreased (as the content of unsubstituted vinyl alcohol units in the protective layer is decreased), the oxygen-cutoff characteristics is reduced, which is disadvantageous in sensitivity: however, developing removability is improved. On the other hand, the protective layer according to the invention uses a combination of a polyvinyl alcohol having a saponification value of 90 mol% or less and a mica compound which will be described later, which makes it possible to improve the film strength of the protective layer and to suppress a reduction in oxygen-cutoff characteristics. As a result, it is possible to attain high sensitization and developing removability at the same time.

Such a polyvinyl alcohol having a saponification value of 90 mol% or less is preferably those having a molecular weight in the range of 300 to 2400. Specific examples of these polyvinyl alcohols include polyvinyl alcohols manufactured by Kuraray Ltd., such as PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8.

- Acid modified polyvinyl alcohol -

Specific examples of the acid-modified polyvinyl alcohol used in the invention include carboxy-modified polyvinyl

alcohols such as itaconic acid- or maleic acid-modified polyvinyl alcohols and sulfonic acid-modified polyvinyl alcohols. Examples of commercial products of the acid-modified polyvinyl alcohols include acid-modified polyvinyl alcohols manufactured by Kuraray Ltd., such as KL-504, KL-506, KL-318, KL-118, KM-618, KM-118 and SK-5102.

The components (selection of the PVA and the mica compound and use of additives), coating amount of the protective layer and the like are selected in consideration of fogging characteristics, adhesion and scratch resistance besides oxygen-cutoff characteristics and developing removability.

Generally, the specific polyvinyl alcohol is contained in an amount in the range preferably from 45 to 95% by mass and more preferably from 60 to 90% by mass based on the total solid content in the protective layer. If the amount of the polyvinyl alcohol is less than 45% by mass, film-forming characteristics is insufficient, bringing about reduced sensitivity. When the amount of the polyvinyl alcohol exceeds 95% by mass, the effect of the specific polyvinyl alcohol on bonding resistance is scarcely produced.

At least one among the above specific polyvinyl alcohols may be used and plural types may be used. In the case of using plural specific polyvinyl alcohols are used together, the total amount of these polyvinyl alcohols also preferably falls in the above range.

In the meantime, adhesion to the image area of the photosensitive layer and scratch resistance are also important for the protective layer according to the invention. Specifically, when a hydrophilic layer comprising a water-soluble polymer is laminated on a lipophilic photosensitive layer, layer peeling is easily caused by a lack of adhesion and the peeled part gives rise to defects such as a film hardening inferior due to the polymerization inhibitive action of oxygen. To cope with this problem, various proposals have been made to improve the adhesion between these two layers. It is described in, for example, U.S.Patent No. 292,501 and U.S.Patent No. 44,563 that satisfactory adhesion is obtained by mixing 20 to 60% by mass of, for example, an acryl type emulsion or water-insoluble vinyl pyrrolidone/vinyl acetate copolymer in a hydrophilic polymer using a polyvinyl alcohol as a major component and laminating the resulting solution on the photosensitive layer.

Any of these known technologies may be applied to the protective layer in the invention insofar as it impairs the effect of the aforementioned specific polyvinyl alcohol and mica compound contained in the protective layer.

Particularly, in the protective layer according to the invention, the aforementioned specific polyvinyl alcohol and polyvinyl pyrrolidone may be used together as binder components from the viewpoint of adhesion to the photosensitive layer, sensitivity and a resistance to generation of unnecessary fogging. Also, the ratio (mass ratio) of the specific polyvinyl alcohol/polyvinyl pyrrolidone is preferably 3/1 or less.

Also, besides this polyvinyl pyrrolidone, compounds which are relatively superior in crystallinity such as acidic celluloses, gelatin, gum arabic, polyacrylic acid and copolymers of these compounds may also be used together.

Colorants (water-soluble dyes) which have high transmittance for light (infrared light in the invention) used to expose the photosensitive layer and can absorb the light having wavelengths which are not involved in exposure may be added in the protective layer according to the invention. The protective layer can be thereby improved in safe-light adaptability.

(Formation of the protective layer)

The protective layer in the invention is formed by preparing a dispersion solution in which a mica compound is dispersed and by applying a protective layer coating solution prepared by compounding this dispersion solution and a binder component containing the above specific polyvinyl alcohol (or an aqueous solution in which a binder component containing the above specific polyvinyl alcohol) to the photosensitive layer.

First, a general method of dispersing the mica compound used in the protective layer will be explained. First, 5 to 10 parts by mass of any of the above-mentioned swellable mica compound as the preferable examples of the mica compound was added to 100 parts by mass of water to adjust the mica compound to water, thereby allowing the mica compound to swell. Then, the swelled mica compound is subjected to a dispersing machine to disperse the mica compound. Examples of the dispersing machine used here include various mills which disperse a target material by mechanically applying force directly to the target material, high-speed stirrer type dispersing machines having large shearing force and dispersing machines applying highly intensified ultrasonic energy. Specific examples of the dispersing machine include a ball mill, sand grinder mill, visco-mill, colloid mill, homogenizer, dissolver, polytron, homomixer, homo-blender, Keddy mill, jet agitator, capillary type emulsifier, liquid siren, electromagnetic distortion type ultrasonic generator and emulsifier having a poleman whistle. A dispersion containing 2 to 15% by mass of the mica compound which dispersion is obtained by dispersing using the above method is highly viscous or has a gel form and has very high preserving stability.

When this dispersion is used to prepare a protective layer coating solution, this dispersion is diluted with water, and the mixture is thoroughly stirred and blended with a binder component containing a specific polyvinyl alcohol (or an aqueous solution in which a binder component containing the specific polyvinyl alcohol is dissolved) to prepare the coating solution.

Known additives such as surfactants improving coatability and water-soluble plasticizers improving the properties of the coating film may be added to this protective layer coating solution. Examples of the water-soluble plasticizer include propionamide, cyclohexanediol, glycerin and sorbitol. Also, a water-soluble (meth)acrylic polymer may also be added. Moreover, known additives that improve adhesion to the photosensitive layer and the stability of the coating solution with time may be added to this coating solution.

No particular limitation is imposed on the method of applying the protective layer according to the invention and the methods described in U.S.Patent No. 3,458,311 or JP-A No. 55-49729 may be applied.

The amount of the protective layer applied in the invention is preferably 0.5 $g/m^2$ to 2.0 $g/m^2$. The amount of the protective layer is more preferably 0.75 $g/m^2$ to 1.5 $g/m^2$. When the amount is less than 0.5 $g/m^2$, the film strength of the protective layer cannot be maintained and scratch resistance is therefore impaired. On the other hand, when the amount exceeds 2.0 $g/m^2$, the light incident to the protective layer by exposure is scattered, causing a deteriorated image.

[Photosensitive layer]

The photosensitive layer of the planographic printing plate precursor according to the invention is a polymerizable negative type photosensitive layer containing an infrared absorber, a polymerization initiator, a polymerizable compound and a binder polymer as essential components, and as required, colorants and other optional components.

The polymerizable negative type photosensitive layer in the invention is sensitive to infrared light and is therefore photosensitive to an infrared laser useful for CTP. The infrared absorber contained in the photosensitive layer is put into an electronically excited state by infrared laser radiation (exposure) highly sensibly. Electronic transfer, energy transfer and heat generation (light-heat conversion function) relating to this electronically excited state act on the polymerization initiator coexisting in the photosensitive layer to cause a chemical change of the polymerization initiator to generate radicals.

Examples of radical-generation mechanisms include (1) a mechanism in which the heat generated by the light-heat conversion function of an infrared absorber thermally decomposes a polymerization initiator (e.g., a sulfonium salt) which will be explained later to generate radicals, (2) a mechanism in which excited electrons generated from an infrared absorber transfer to a polymerization initiator (e.g., an activated halogen compound) to generate radicals and (3) a mechanism in which electrons generated from a polymerization initiator (e.g., a borate compound) transfer to an excited infrared absorber to generate radicals. Then, a polymerizable compound is allowed to enter into a polymerization reaction by the generated radicals to cure the exposed portion, forming an image area.

The photosensitive layer contains the infrared absorber in the planographic printing plate precursor of the invention and the planographic printing plate precursor is therefore particularly suitable to plate-making in which an image is formed directly by an infrared laser having a wavelength of 750 nm to 1400 nm. The planographic printing plate precursor of the invention can develop higher image forming characteristics than conventional planographic printing plate precursors.

Each component contained in the photosensitive layer according to the invention will be explained hereinbelow.

(Infrared absorber)

The photosensitive layer according to the invention contains an infrared absorber in order to develop an energy transfer function and a light-heat conversion function.

The infrared absorber is put into an electronic excited state highly sensibly by infrared laser radiation (exposure) and electronic transfer, energy transfer and heat generation (light-heat conversion function) relating to this electronically excited state act on the initiator which will be described later to cause a chemical change of the polymerization initiator to generate radicals.

The infrared absorber used in the invention is preferably a dye or a pigment having an absorption maximum at a wavelength in the range of 750 nm to 1400 nm.

The dye may be any known commercial dye including those described in publications such as *Senryo Binran* (Dye Handbook) (published in 1970 and compiled by the Society of Synthetic Organic Chemistry, Japan). Examples of such dyes include azo dyes, metal complex salt azo dyes, pyrazolone azo dyes, naphthoquinone dyes, anthraquinone dyes, phthalocyanine dyes, carbonium dyes, quinone imine dyes, methine dyes, cyanine dyes, squarylium dyes, pyrylium salts, and metal thiolate complexes.

Preferable dyes include cyanine dyes such as those described in patent documents such as JP-A Nos. 58-125246, 59-84356, 59-202829, and 60-78787, and the methine dyes described in JP-A Nos. 58-173696, 58-181690, 58-194595, etc.. Further, the naphthoquinone dyes described in JP-A Nos. 58-112793, 58-224793, 59-48187, 59-73996, 60-52940, 60-63744, etc., the squarylium dyes described in JP-A No. 58-112792, etc., and the cyanine dyes described in Britsh Patent No. 434,875 are also preferably used.

The near infrared ray-absorbing sensitizers described in US Patent No. 5,156,938 are also preferably used. Also preferably used are the substituted aryl benzo(thio) pyrylium salts described in US Patent No. 3,881,924; the

trimethine thiapyrylium salts described in JP-A No. 57-142645 (US Patent No. 4,327,169); the pyrylium type compounds described in JP-A Nos. 58-181051, 58-220143, 59-41363, 59-84248, 59-84249, 59-146063, and 59-146061; the cyanine dyes described in JP-A No. 59-216146; the pentamethine thiopyrylium salts described in US Patent No. 4,283,475; and the pyrylium compounds described in JP-B Nos. 5-13514 and 5-19702. Other preferable examples of the dyes include the near infrared ray-absorbing dyes of the formulae (I) and (II) described in US Patent No. 4,756,993.

Other preferable examples of the infrared absorbing dye in the present invention include specific indolenine cyanine dyes described in Japanese Patent Application Nos. 2001-6326 and 2001-237840, as shown below.

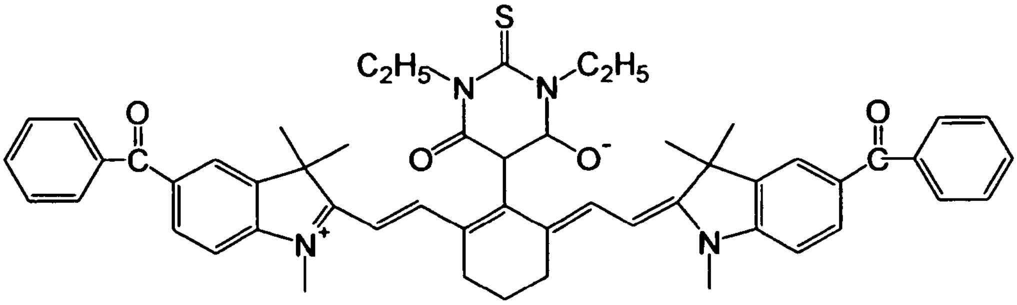

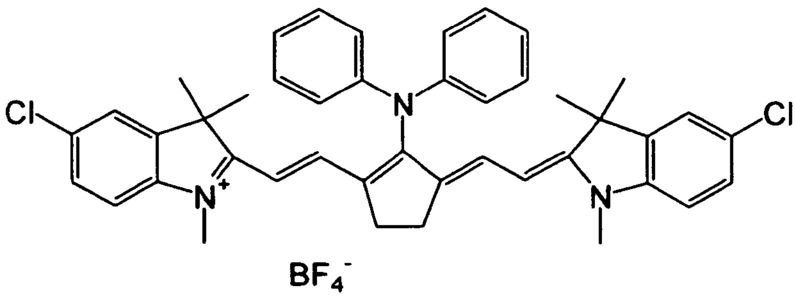

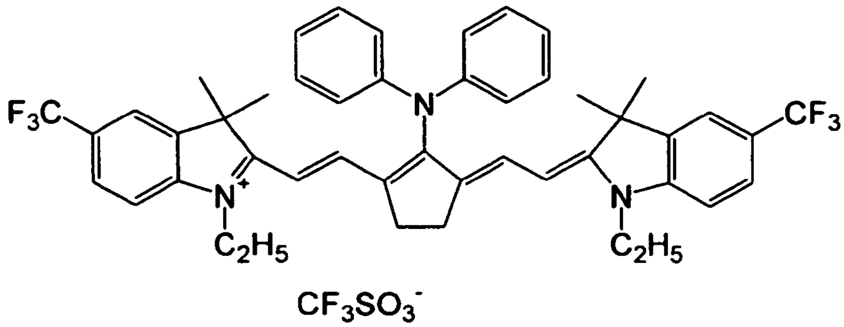

Particularly preferable among these dyes are cyanine dyes, squarylium dyes, pyrylium salts, nickelthiolate complexes and indolenine cyanine dyes. The dyes are more preferably cyanine dyes and indolenine cyanine dyes, still more preferably cyanine dyes represented by the formula (a).

Formula (a)

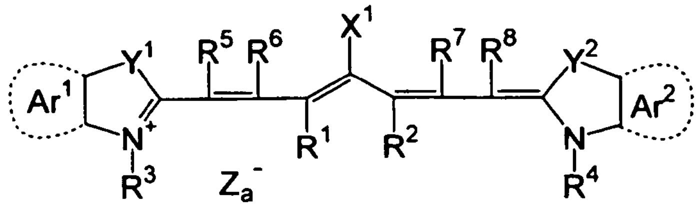

In the formula (a), $X^1$ represents a hydrogen atom, a halogen atom, $-NPh_2$, $X^2$-$L^1$ or a group shown below. $X^2$ represents an oxygen atom, a nitrogen atom or a sulfur atom, $L^1$ represents a hydrocarbon group having 1 to 12 carbon atoms, an aromatic ring having a heteroatom, and a hydrocarbon group having 1 to 12 carbon atoms containing a heteroatom. The heteroatom refers to N, S, O, halogen atom or Se. $Xa^-$ has the same meaning as that of $Za^-$ defined later, and $R^a$ represents a substituent group selected from a hydrogen atom, an alkyl group, an aryl group, a substituted or unsubstituted amino group, and a halogen atom.

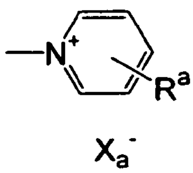

$R^1$ and $R^2$ independently represent a hydrocarbon group having 1 to 12 carbon atoms. For the purpose of storability of the coating solution of the recording layer, each of $R^1$ and $R^2$ is preferably a hydrocarbon group having 2 or more carbon atoms, and more preferably $R^1$ and $R^2$ are linked to each other to form a 5- or 6-memberred ring.

$Ar^1$ and $Ar^2$ may be the same or different and each represents an aromatic hydrocarbon group which may have a substituent group. The aromatic hydrocarbon group is preferably a benzene ring or a naphthalene ring. The substituent group is preferably a hydrocarbon group having 12 or less carbon atoms, a halogen atom or an alkoxy group having 12 or less carbon atoms. $Y^1$ and $Y^2$ may be the same or different and each represents a sulfur atom or a dialkyl methylene group having 12 or less carbon atoms. $R^3$ and $R^4$ may be the same or different and each represents a hydrocarbon group having 20 or less carbon atoms, which may have a substituent group. The substituent group is preferably an alkoxy group having 12 or less carbon atoms, a carboxyl group or a sulfo group. $R^5$, $R^6$, $R^7$ and $R^8$ may be the same or different and each represents a hydrogen atom or a hydrocarbon group having 12 or less carbon atoms. Each of $R^5$, $R^6$, $R^7$ and $R^8$ is preferably a hydrogen atom because the starting material is easily available. $Za^-$ represents a counter anion. However, when the cyanine dye represented by the formula (a) has an anionic substituent group in its structure and does not necessitate neutralization of the charge, $Za^-$ is not necessary. For the purpose of storability of the coating solution of the photosensitive layer, $Za^-$ is preferably a halogen ion, a perchlorate ion, a tetrafluoroborate ion, a hexafluorophosphate ion or a sulfonate ion, particularly preferably a perchlorate ion, a hexafluorophosphate ion or an aryl sulfonate ion.

Examples of the cyanine dyes represented by the formula (a), which can be preferably used in the present invention, include those described in columns [0017] to [0019] in JP-A No. 2001-133969.

Other preferable examples of the infrared absorbing agent in the present invention include specific indolenine cyanine dyes described in Japanese Patent Application Nos. 2001-6326 and 2001-237840 supra.

The cyanine dyes represented by formula (a) is particularly preferably a dye which does not contain a halogen ion as a counter ion.

Examples of the pigment includes commercially available pigments and those described in the Color Index (C. I.) Handbook, Saishin Ganryo Binran (Latest Dye Handbook) (published in 1977 and compiled by the Japanese Society of Pigment Technology); Saishin Ganryho Oyo Gijyutsu (Latest Pigment Applied Technology) (published in 1986 by CMC Publishing Co., Ltd.); and Insatsu Inki Gijyutsu (Printing Ink Technology) (published in 1984 by CMC Publishing Co., Ltd.).

Examples of the pigment include black pigments, yellow pigments, orange pigments, brown pigments, red pigments, violet pigments, blue pigments, green pigments, fluorescent pigments, metallic powder pigments, and other pigments such as polymer-binding dyes. Specific examples of preferable pigments include insoluble azo pigments, azo lake pigments, condensed azo pigments, chelate azo pigments, phthalocyanine type pigments, anthraquinone type

pigments, perylene and perinone type pigments, thioindigo type pigments, quinacridone type pigments, dioxazine type pigments, isoindolinone type pigments, quinophthalone type pigments, dyed lake pigments, azine pigments, nitroso pigments, nitro pigments, natural pigments, fluorescent pigments, inorganic pigments, and carbon black, which is preferable among these.

The pigments may or may not be subjected to surface treatment. Methods of surface treatment include coating the surface with resin or wax; allowing a surfactant to adhere to the surface; and bonding a reactive material (e.g., a silane coupling agent, an epoxy compound, a polyisocyanate, etc.) onto the surface of the pigment. These methods of surface treatment are described in Kinzoku Sekken No Seishitsu To Oyo (Properties and Application of Metallic Soap) (Sachi Shobo); Insatsu Inki Gijyutsu (Printing Ink Technology) (published in 1984 by CMC Publishing Co., Ltd.); and Saishin Ganryho Oyo Gijyutsu (Latest Pigment Applied Technology) (published in 1986 by CMC Publishing Co., Ltd.).

The particle diameters of the pigments are in the range of preferably 0.01 to 10 μm, more preferably 0.05 to 1 μm, most preferably 0.1 to 1 μm. When the particle diameters are in the preferable range, dispersion stability of the pigments in the coating solution and uniformity of the photosensitive layer can be achieved.

In the method of dispersing the pigment, known dispersing machines used widely in production of inks or toners and dispersing techniques can be suitably selected. Examples of suitable dispersing machines include a supersonic dispersing device, sand mill, attritor, pearl mill, super mill, ball mill, impeller, disperser, KD mill, colloid mill, dynatron, triple roll mill, press kneader, etc. These are described in detail in the aforementioned Saishin Ganryho Oyo Gijyutsu (Latest Newest Pigment Applied Technology) (published in 1986 by CMC Publishing Co., Ltd.).

The aforementioned infrared absorbing agents, along with other components, may be added to the same layer or to a separately provided layer in the photosensitive layer of the invention.

These infrared absorbing agents can be added in a ratio of 0.01 to 50% by mass, more preferably 0.1 to 10% by mass, and as the infrared absorbing agent, the dye can be added in the range of 0.5 to 10% by mass, and the pigment can be added in the range of 0.1 to 10% by mass, based on a total solid content in the photosensitive layer, from the viewpoint of uniformity and durability of the photosensitive layer.

(Polymerization Initiator)

Any compound may be used as the polymerization initiator used in the invention insofar as it has the abilities to initiate and to progress a reaction for curing a polymerizable compound which will be explained later and generates radicals by supplying energy: examples of these compounds include thermally decomposable radical generators which are decomposed by heat to generate radicals, electron transfer type radical generators which receive excited electrons of an infrared absorber to generate radicals or electron transfer type radical generators whose electrons transfer to an excited infrared absorber to generate radicals. Examples of these compounds include onium salts, activated halogen compounds, oxime ester compounds and borate compounds. Two or more of these compounds may be used together. In the invention, onium salts are preferable and among the onium salts, sulfonium salts are particularly preferable.

The sulfonium salt polymerization initiator used preferably in the present invention includes onium salts represented by the following formula (1).

Formula (1)

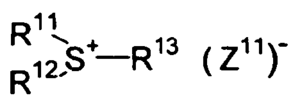

In the formula (1), $R^{11}$, $R^{12}$ and $R^{13}$ each independently represent a hydrocarbon group having 20 or less carbon atoms, which may have a substituent group. The substituent group is preferably a halogen atom, a nitro group, an alkyl group having 12 or less carbon atoms, an alkoxy group having 12 or less carbon atoms, or an aryloxy group having 12 or less carbon atoms. $(Z^{11})^-$ represents a counter ion selected from the group consisting of a halogen ion, a perchlorate ion, a tetrafluoroborate ion, a hexafluorophosphate ion, a carboxylate ion and a sulfonate ion, preferably a perchlorate ion, a hexafluorophosphate ion, a carboxylate ion and an aryl sulfonate ion.

Hereinafter, examples of the onium salts ([OS-1] to [OS-12]) represented by the formula (1) are mentioned, but the onium salts are not limited thereto.

[ OS-1 ]

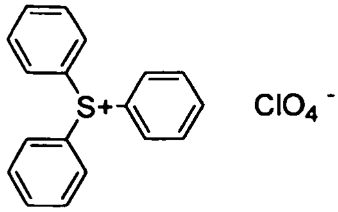

[ OS-2 ]

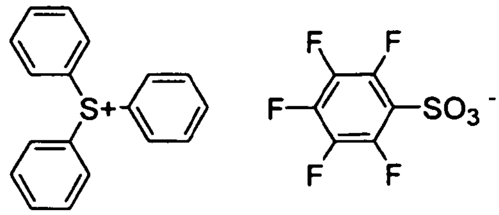

[ OS-3 ]

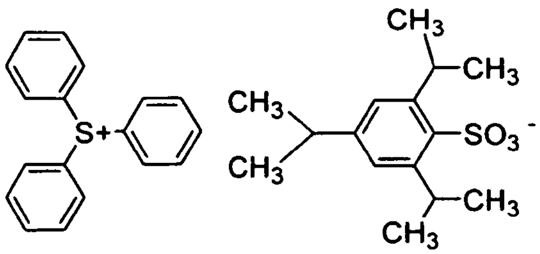

[ OS-4 ]

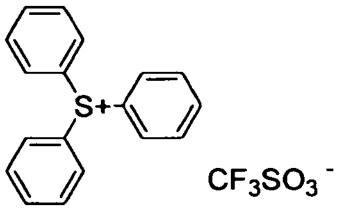

[ OS-5 ]

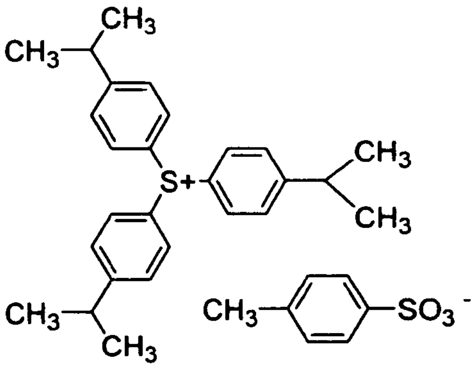

[ OS-6 ]

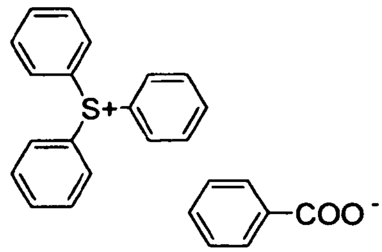

[ OS-7 ]

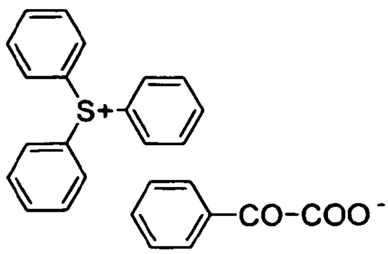

[ OS-8 ]

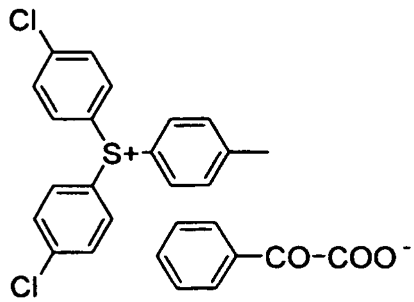

[ OS-9 ]

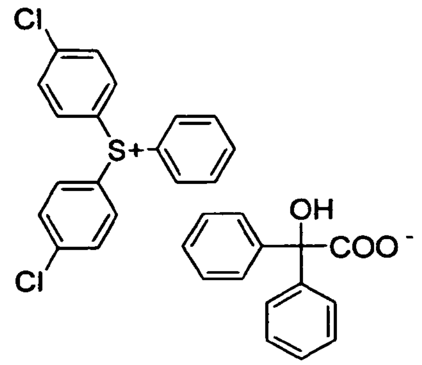

[ OS-10]

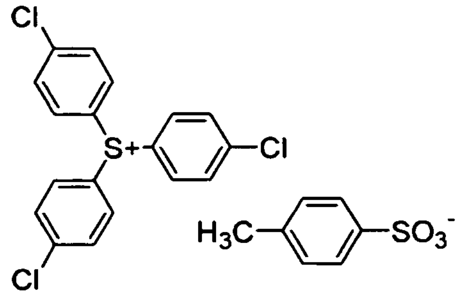

[ OS-11 ]

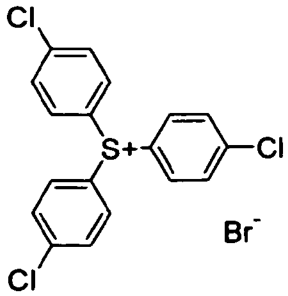

[ OS-12 ]

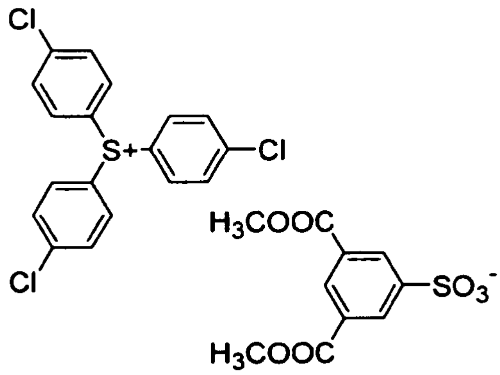

In addition to those described above, specific aromatic sulfonium salts described in JP-A Nos. 2002-148790, 2002-350207 and 2002-6482 can also be preferably used.

In the present invention, other polymerization initiators (other radical generating agents) can be used than the sulfonium salt polymerization initiator. The other radical generating agents include onium salts (excluding sulfonium salts), triazine compounds having a trihalomethyl group, peroxides, azo-type polymerization initiators, azide compounds, quinone diazide, activated halogen compounds, oxime ester compounds and triaryl monoalkyl borate compounds. Among these compounds, the onium salts are highly sensitive and preferably used. These polymerization initiators (radical generating agents) can be used in combination with the sulfonium salt polymerization initiator.

Examples of the onium salts which can be used preferably in the present invention include iodonium salts and diazonium salts. In the present invention, these onium salts function not as acid generating agents but as radical polymerization initiators.

Examples of the onium salts used preferably in the present invention include onium salts represented by the formulae (2) and (3).

Formula (2) $Ar^{21}\text{-}I^{+}\text{-}Ar^{22}\ (Z^{21})^{-}$

Formula (3) $Ar^{31}\text{-}N^{+}\equiv N\ (Z^{31})^{-}$

In the formula (2), $Ar^{21}$ and $Ar^{22}$ each independently represent an aryl group having 20 or less carbon atoms, which may have a substituent group. When this aryl group has a substituent group, the substituent group is preferably a halogen atom, a nitro group, an alkyl group having 12 or less carbon atoms, an alkoxy group having 12 or less carbon atoms, or an aryloxy group having 12 or less carbon atoms. $(Z^{21})^{-}$ represents a counter ion having the same meaning as defined for $(Z^{11})^{-}$.

In the formula (3), $Ar^{31}$ represents an aryl group having 20 or less carbon atoms, which may have a substituent group. The substituent group is preferably a halogen atom, a nitro group, an alkyl group having 12 or less carbon atoms, an alkoxy group having 12 or less carbon atoms or an aryloxy group having 12 or less carbon atoms, an alkylamino

group having 12 or less carbon atoms, a dialkylamino group having 12 carbon atoms, an arylamino group having 12 or less carbon atoms, or a diarylamino group having 12 or less carbon atoms. $(Z^{31})^-$ represents a counter ion having the same meaning as defined for $(Z^{11})^-$.

Preferable examples of the iodonium salts ([OI-1] to [OI-10]) represented by the formula (2) and the diazonium salts ([ON-1] to [ON-5]) represented by the formula (3) are mentioned below, but the onium salts are not limited thereto.

[ OI-1 ]

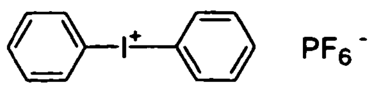

[ OI-2 ]

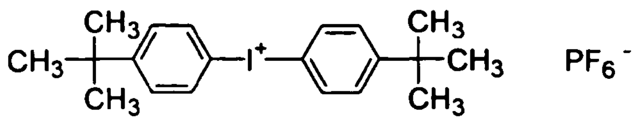

[ OI-3 ]

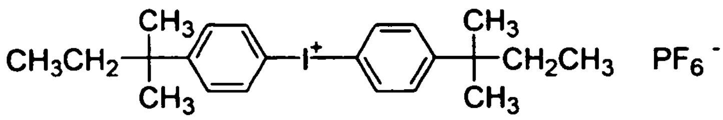

[ OI-4 ]

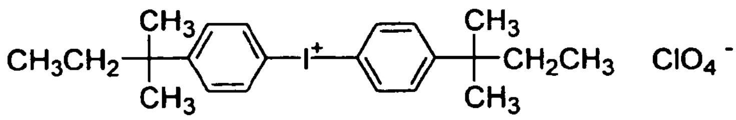

[ OI-5 ]

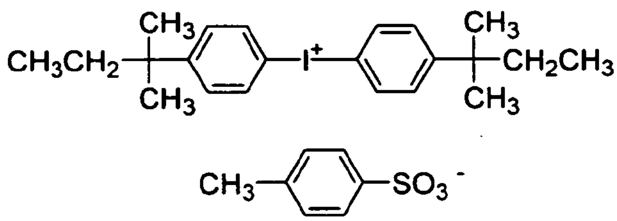

[ OI-6 ]

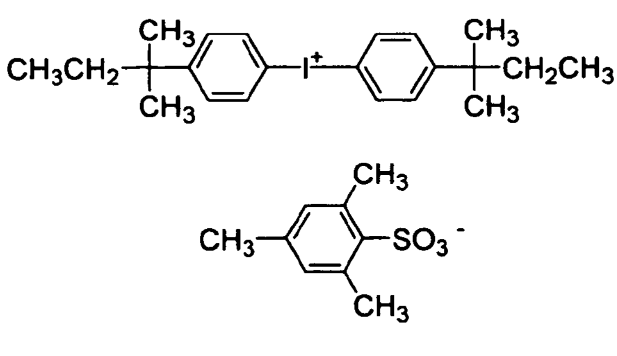

[ OI-7 ]

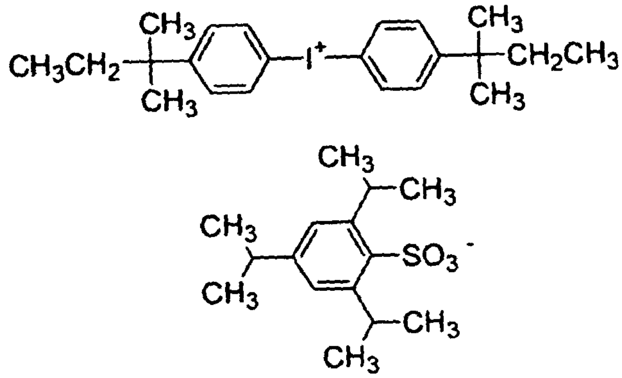

[ OI-8 ]

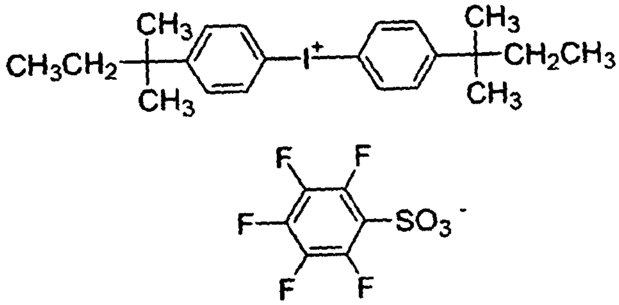

[ OI-9 ]

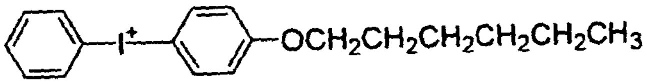

[ OI-10 ]

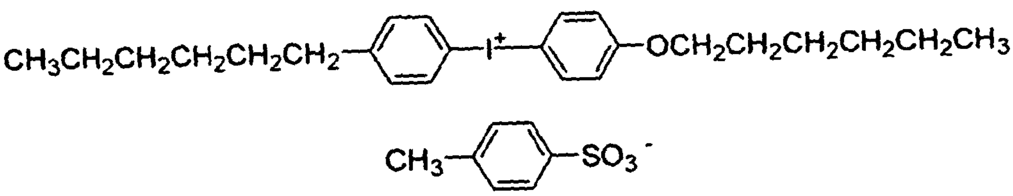

[ ON-1 ]

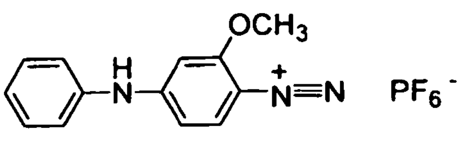

[ ON-2 ]

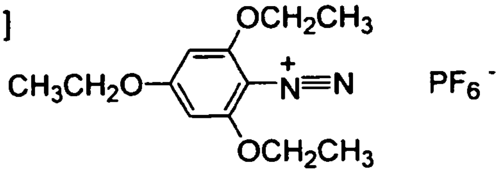

[ ON-3 ]

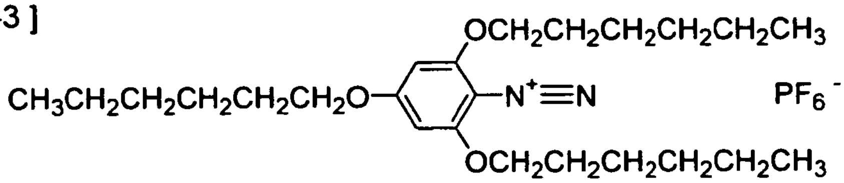

[ ON-4 ]

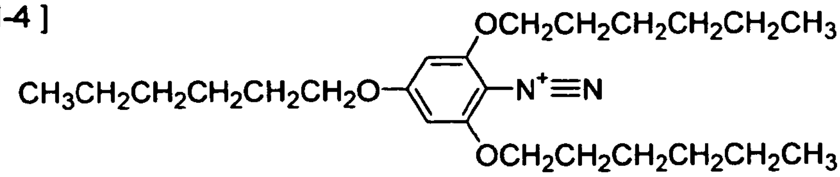

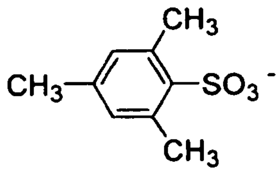

[ ON-5 ]

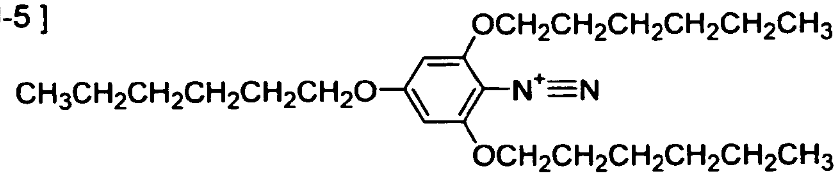

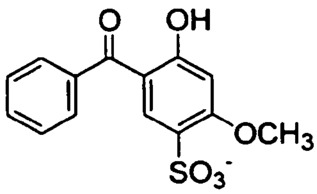

In the present invention, examples of the onium salts preferably used as the polymerization initiator (radical generating agent) include those described in JP-A No. 2001-133696.

The polymerization initiator (radical-generating agent) used in the present invention has a maximum absorption wavelength of preferably 400 nm or less, more preferably 360 nm or less. By using the radical-generating agent having its absorption wavelength in the UV range, the planographic printing plate precursor can be handled under an incandescent lamp.

From the viewpoint of sensitivity and the generation of smudging in a non-image at the time of printing, the total content of the polymerization initiator in the present invention is 0.1 to 50% by mass, and preferably 0.5 to 30% by

mass, more preferably 1 to 20% by mass, based on a total solid content in the photosensitive layer.

In the present invention, only one polymerization initiator or two or more polymerization initiators may be used. When two or more polymerization initiators are used in combination, for example, two or more sulfonium salt polymerization initiators, which are preferably used, can be used, or the sulfonium salt polymerization initiator can be used in combination with another polymerization initiator.

When the sulfonium salt polymerization initiator is used in combination with other polymerization initiator, the ratio (ratio by mass) of the sulfonium salt polymerization initiator to the other polymerization initiator is preferably 100/1 to 100/50, more preferably 100/5 to 100/25.

The polymerization initiator, along with other components, may be added to the same layer or to a separately provided layer.

In the case of using a highly sensitive sulfonium salt polymerization initiator which is desirable as the polymerization initiator in the photosensitive layer in the invention, a radial polymerization reaction proceeds efficiently to make the formed image very strong. Accordingly, a planographic printing plate having an oxygen-cutoff function obtained by the high protective layer which will be explained later and also high strength of an image area can be manufactured, with the result that printing durability is more improved. Also, because the sulfonium salt polymerization initiator is itself superior in stability with time, there is the advantage that the generation of an undesired polymerization reaction is suppressed efficiently when the manufactured planographic printing plate precursor is stored.

(Polymerizable compound)

The polymerizable compound used in the present invention is an addition-polymerizable compound having at least one ethylenically unsaturated double bond, and is selected from compounds each having at least one (preferably two or more) ethylenically unsaturated bond. A group of such compounds is known widely in this industrial field, and in the present invention these compounds can be used without any particular limitation. These compounds occur in chemical forms such as monomers, prepolymers, that is, dimers, trimers and oligomers, as well as mixtures thereof and copolymers thereof. Examples of such monomers and copolymers include unsaturated carboxylic acids (e.g., acrylic acid, methacrylic acid, itaconic acid, crotonic acid, isocrotonic acid, maleic acid etc.) and esters and amides thereof, and preferably used among these compounds are esters between unsaturated carboxylic acids and aliphatic polyvalent alcohol compounds and amides between unsaturated carboxylic acids and aliphatic polyvalent amine compounds. Also preferably used among these compounds are unsaturated carboxylates having nucleophilic substituent groups such as hydroxyl group, amino group, mercapto group etc., addition-reaction products of amides with monofunctional or multifunctional isocyanates or epoxy compounds, and dehydration condensation reaction products of amides with monofunctional or multifunctional carboxylic acids. Also preferably used among these compounds are unsaturated carboxylates having electrophilic substituent groups such as isocyanate group, epoxy group etc., addition-reaction products of amides with monofunctional or multifunctional alcohols, amines or thiols, unsaturated carboxylates having eliminating substituent groups such as halogen group, tosyloxy group etc., and substitution-reaction products of amides with monofunctional or multifunctional alcohols, amines or thiols. A group of those compounds wherein the above-described carboxylic acids have been replaced by unsaturated phosphonic acid, styrene, vinyl ethers etc., can also be used.

As the ester monomers between aliphatic polyvalent alcohols and unsaturated carboxylic acids, the acrylates include ethylene glycol diacrylate, triethylene glycol diacrylate, 1,3-butane diol diacrylate, tetramethylene glycol diacrylate, propylene glycol diacrylate, neopentyl glycol diacrylate, trimethylol propane triacrylate, trimethylol propane tri (acryloyloxypropyl)ether, trimethylol ethane triacrylate, hexane diol diacrylate, 1,4-cyclohexane diol diacrylate, tetraethylene glycol diacrylate, pentaerythritol diacrylate, pentaerythritol triacrylate, pentaerythritol tetracrylate, dipentaerythritol diacrylate, dipentaerythritol hexacrylate, sorbitol triacrylate, sorbitol tetracrylate, sorbitol pentacrylate, sorbitol hexacrylate, tri(acryloyloxyethyl) isocyanurate, polyester acrylate oligomers etc.

The methacrylates include tetramethylene glycol dimethacrylate, triethylene glycol dimethacrylate, neopentyl glycol dimethacrylate, trimethylol propane trimethacrylate, trimethylol ethane trimethacrylate, ethylene glycol dimethacrylate, 1,3-butane diol dimethacrylate, hexane diol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethyl methane, bis [p-(methacryloxyethoxy)phenyl]dimethyl methane etc.

The itaconates include ethylene glycol diitaconate, propylene glycol diitaconate, 1,3-butane diol diitaconate, 1,4-butane diol diitaconate, tetramethylene glycol diitaconate, pentaerythritol diitaconate, sorbitol tetraitaconate etc.

The crotonates include ethylene glycol dicrotonate, tetramethylene glycol dicrotonate, pentaerythritol dicrotonate, sorbitol tetradicrotonate etc.

The isocrotonates include ethylene glycol diisocrotonate, pentaerythritol diisocrotonate, sorbitol tetraisocrotonate etc.

The maleates include ethylene glycol dimaleate, triethylene glycol dimaleate, pentaerythritol dimaleate, sorbitol

tetramaleate etc.

Other preferably used esters include, for example, aliphatic alcohol-based esters described in Japanese Patent Application Publication (JP-B) Nos. 46-27926, 51-47334 and Japanese Patent Application Laid-Open (JP-A) No. 57-196231, those having an aromatic skeleton described in JP-A Nos. 59-5240, 59-5241 and 2-226149, and those having an amino group described in JP-A No. 1-165613. The ester monomers can also be used as a mixture.

The amide monomers between aliphatic polyvalent amine compounds and unsaturated carboxylic acids include, for example, methylene bis-acrylamide, methylene bis-methacrylamide, 1,6-hexamethylene bis-acrylamide, 1,6-hexamethylene bis-methacrylamide, diethylene triamine trisacrylamide, xylylene bisacrylamide, xylylene bismethacrylamide etc. Preferable examples of other amide type monomers include those having a cyclohexylene structure described in JP-B No. 54-21726.

Urethane type addition-polymerizable compounds produced by addition reaction between isocyanates and hydroxyl groups are also preferable, and examples thereof includes vinyl urethane compounds containing two or more polymerizable vinyl groups in one molecule, which are prepared by adding vinyl monomers containing a hydroxyl group shown in the formula below to polyisocyanates compound having two or more isocyanate groups in one molecule as described in JP-B No. 48-41708.

Formula $CH_2=C(R^a)COOCH_2CH(R^b)OH$

In the formula, $R^a$ and $R^b$ each independently represent H or $CH_3$.

Urethane acrylates described in JP-A No. 51-37193, JP-B Nos. 2-32293 and 2-16765 and urethane compounds having an ethylene oxide-type skeleton described in JP-B Nos. 58-49860, 56-17654, 62-39417 and 62-39418 are also preferable. Addition-polymerizable compounds having an amino structure or sulfide structure in the molecule as described in JP-A Nos. 63-277653, 63-260909 and 1-105238 can be used to prepare photopolymerizable compositions extremely excellent in photosensitizing speed.

As other examples, multifunctional acrylates and methacrylates such as polyacrylates and epoxy acrylates obtained by reacting epoxy resin with (meth)acrylic acid as described in JP-A No. 48-64183, JP-B Nos. 49-43191 and 52-30490 can be mentioned. Specific unsaturated compounds described in JP-B Nos. 46-43946, 1-40337 and 1-40336 and vinyl phosphonic acid-type compounds described in JP-A No. 2-25493 can also be mentioned. In some cases, a structure containing a perfluoroalkyl group described in JP-A No. 61-22048 is preferably used. Photo-curable monomers and oligomers described in the Journal of Japanese Adhesive Society, vol. 20, No. 7, pp.300-308 (1984) can also be used.

Details of method of using these addition-polymerizable compounds, for example, the structure thereof, single use or use in combination thereof, and the amount to be used, can be arbitrarily determined depending on the final performance and design of the material. For example, they are selected from the following viewpoints. From the viewpoint of photosensitizing speed, the additional-polymerizable compounds preferably have many unsaturated groups in one molecule, and in many cases, they are preferably bifunctional or more. In order to increase the strength of image areas, i.e. the cured layer, they are preferably trifunctional or more. It is also effective to use a method of regulating both photosensitivity and strength by combined use of compounds (e.g. acrylates, methacrylates, styrene type compounds, and vinyl ether type compounds) having different functionalities and different polymerizable groups. The high-molecular compounds or highly hydrophobic compounds, though being excellent in photosensitizing speed and film strength, may be undesirable in some cases in respect of developing speed and precipitation in the developing solution. The method of selecting and using the addition-polymerizable compound is an important factor for compatibility and dispersibility with other components (e.g. a binder polymer, an initiator, a colorant etc.) in the photosensitive layer composition, and the compatibility may be improved by using e.g. a low-purity compound or a combination of two or more compounds.

In a planographic printing plate precursor of the invention, a specific structure can be selected for the purpose of improving adhesiveness to a support, a protective layer, described later, etc.

As to the content of the addition polymerizable compound in the photosensitive layer composition, the addition polymerizable compound is preferably used in an amount of 5 to 80% by mass and more preferably 40 to 75% by mass based on a total solid content in the photosensitive layer composition from the viewpoint of sensitivity, generation of phase separation, adhesion of the photosensitive layer and also precipitation characteristics from a developing solution.

These compounds may be used singly or in combination thereof. From the viewpoints of the degree of inhibition of polymerization by oxygen, resolution, fogging, a change in reflectance and surface adhesion, a suitable structure, compounding and amount thereof can be arbitrarily selected in the method of using the addition-polymerizable compound. In a planographic printing plate precursor of the invention, a layer structure and a coating method such as undercoating and overcoating can also be used as necessary.

(Binder polymer)

From the viewpoint of improving layer-forming properties, the photosensitive layer in the present invention

preferably comprises a binder polymer, particularly preferably a binder polymer having a repeating unit represented by the formula (i). The binder polymer having a repeating unit represented by the formula (i) is also referred to as "specific binder polymer" and described in more detail below.

Formula (i)

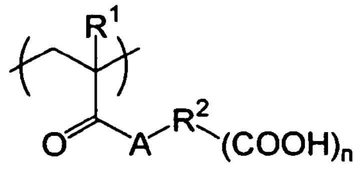

In the formula (i), $R^1$ represents a hydrogen atom or a methyl group; $R^2$ represents a linking group containing two or more atoms selected from the group consisting of a carbon atom, a hydrogen atom, an oxygen atom, a nitrogen atom and a sulfur atom, and the total number of atoms in $R^2$ is 2 to 82; A represents an oxygen atom or $-NR^3-$ in which $R^3$ represents a hydrogen atom or a monovalent hydrocarbon group having 1 to 10 carbon atoms; and n is an integer from 1 to 5.

$R^1$ in the formula (i) represents a hydrogen atom or a methyl group, preferably a methyl group.

The linking group represented by $R^2$ in the formula (i) is a linking group containing two or more atoms selected from the group consisting of a carbon atom, a hydrogen atom, an oxygen atom, a nitrogen atom and a sulfur atom, and the total number of atoms in $R^2$ is 2 to 82, preferably 2 to 50, and more preferably 2 to 30. The total number of atoms refers to the number of atoms including atoms in a substituent group, if any, on the linking group. Specifically, the number of carbon atoms in the main skeleton of the linking group represented by $R^2$ is preferably 1 to 30, more preferably 3 to 25, still more preferably 4 to 20, and most preferably 5 to 10. The "main skeleton of the linking group" in the present invention refers to an atom or an atomic group used in linking A to the terminal COOH in the formula (i), and when a plurality of linkages are present, the main skeleton refers to an atom or an atomic group constituting a linkage having the smallest number of atoms. Accordingly, when the linking group has a cyclic structure, its linking sites (for example, o-, m-, p-, etc.) are different in the number of atoms to be introduced into them.

Specific examples of the linking group represented by $R^2$ include an alkylene group, a substituted alkylene group, an arylene group and a substituted arylene group, and these divalent groups may be in a chain structure bound to one another via amide or ester linkages.

Linking groups in the chain structure include ethylene, propylene, etc. A structure comprising these alkylene groups bound to one another via ester linkages is also preferable.

The linking group represented by $R^2$ in formula (i) is preferably a (n+1)-valent hydrocarbon group having an alicyclic structure having 3 to 30 carbon atoms. Examples thereof include (n+1)-valent hydrocarbon groups obtained by removing (n+1) hydrogen atoms on arbitrary carbon atoms constituting compounds having an alicyclic structure, such as cyclopropane, cyclopentane, cyclohexane, cycloheptane, cyclooctane, cyclodecane, dicyclohexyl, tertiary cyclohexyl and norbornane which may be substituted with one or more arbitrary substituent groups. $R^2$ is preferably the one containing 3 to 30 carbon atoms including carbon atoms in a substituent group if any.

The arbitrary carbon atoms in a compound constituting an alicyclic structure may be substituted with one or more heteroatoms selected from the group consisting of a nitrogen atom, an oxygen atom and a sulfur atom. In terms of printing durability, $R^2$ is preferably a (n+1)-valent hydrocarbon group having an alicyclic structure which may have a substituent group having 5 to 30 carbon atoms comprising two or more rings, such as a condensed polycyclic aliphatic hydrocarbon, a crosslinked alicyclic hydrocarbon, spiroaliphatic hydrocarbon, and combined aliphatic hydrocarbon rings (plural rings combined directly or via linking groups). The number of carbon atoms refers to the number of carbon atoms including carbon atoms in a substituent group, if any.

The linking group represented by $R^2$ is preferably a group containing 5 to 10 atoms constituting a main structure of the linking group, having a cyclic structure containing an ester linkage or the cyclic structure described above.

A substituent group which can be introduced into the linking group represented by $R^2$ includes a monovalent non-metal atomic group excluding hydrogen, and examples thereof include a halogen atom (-F, -Br, -Cl, -I), hydroxyl group, alkoxy group, aryloxy group, mercapto group, alkyl thio group, aryl thio group, alkyl dithio group, aryl dithio group, amino group, N-alkyl amino group, N,N-dialkyl amino group, N-aryl amino group, N,N-diaryl amino group, N-alkyl-N-aryl amino group, acyloxy group, carbamoyloxy group, N-alkylcarbamoyloxy group, N-aryl carbamoyloxy group, N,N-dialkyl carbamoyloxy group, N,N-diaryl carbamoyloxy group, N-alkyl-N-aryl carbamoyloxy group, alkyl sulfoxy group, aryl sulfoxy group, acyl thio group, acyl amino group, N-alkyl acyl amino group, N-aryl acyl amino group, ureido group, N'-alkyl ureido

group, N',N'-dialkyl ureido group, N'-aryl ureido group, N',N'-diaryl ureido group, N'-alkyl-N'-aryl ureido group, N-alkyl ureido group, N-aryl ureido group, N'-alkyl-N-alkyl ureido group, N'-alkyl-N-aryl ureido group, N',N'-dialkyl-N-alkyl ureido group, N',N'-dialkyl-N-aryl ureido group, N'-aryl-N-alkyl ureido group, N'-aryl-N-aryl ureido group, N',N'-diaryl-N-alkyl ureido group, N',N'-diaryl-N-aryl ureido group, N'-alkyl-N'-aryl-N-alkyl ureido group, N'-alkyl-N'-aryl-N-aryl ureido group, alkoxy carbonyl amino group, aryloxy carbonyl amino group, N-alkyl-N-alkoxycarbonyl amino group, N-alkyl-N-aryloxy carbonyl amino group, N-aryl-N-alkoxycarbonyl amino group, N-aryl-N-aryloxycarbonyl amino group, formyl group, acyl group, carboxyl group and its conjugated basic group, alkoxy carbonyl group, aryloxy carbonyl group, carbamoyl group, N-alkyl carbamoyl group, N,N-dialkyl carbamoyl group, N-aryl carbamoyl group, N,N-diaryl carbamoyl group, N-alkyl-N-aryl carbamoyl group, alkyl sulfinyl group, aryl sulfinyl group, alkyl sulfonyl group, aryl sulfonyl group, sulfo group ($-SO_3H$) and its conjugated basic group, alkoxy sulfonyl group, aryloxy sulfonyl group, sulfinamoyl group, N-alkyl sulfinamoyl group, N,N-dialkyl sulfinamoyl group, N-aryl sulfinamoyl group, N,N-diaryl sulfinamoyl group, N-alkyl-N-aryl sulfinamoyl group, sulfamoyl group, N-alkyl sulfamoyl group, N,N-dialkyl sulfamoyl group, N-aryl sulfamoyl group, N,N-diaryl sulfamoyl group, N-alkyl-N-aryl sulfamoyl group, N-acyl sulfamoyl group and its conjugated basic group, N-alkyl sulfonyl sulfamoyl group ($-SO_2NHSO_2$ (alkyl)) and its conjugated basic group, N-aryl sulfonyl sulfamoyl group ($-SO_2NHSO_2$(aryl)) and its conjugated basic group, N-alkyl sulfonyl carbamoyl group ($-CONHSO_2$(alkyl)) and its conjugated basic group, N-aryl sulfonyl carbamoyl group ($-CONHSO_2$(aryl)) and its conjugated basic group, alkoxy silyl group ($-Si(O\text{-alkyl})_3$), aryloxy silyl group ($-Si(O\text{-aryl})_3$), hydroxylyl group ($-Si(OH)_3$) and its conjugated basic group, pohsphono group ($-PO_3H_2$) and its conjugated basic group, dialkyl phosphono group ($-PO_3(\text{alkyl})_2$), diaryl phosphono group ($-PO_3(\text{aryl})_2$), alkyl aryl phosphono group ($-PO_3$(alkyl)(aryl)), monoalkyl phosphono group ($-PO_3H$(alkyl)) and its conjugated basic group, monoaryl phosphono group ($-PO_3H$(aryl)) and its conjugated basic group, phosphonoxy group ($-OPO_3H_2$) and its conjugated basic group, dialkyl phosphonoxy group ($-OPO_3(\text{alkyl})_2$), diaryl phosphonoxy group ($-OPO_3(\text{aryl})_2$), alkyl aryl phosphonoxy group ($-OPO_3$(alkyl)(aryl)), monoalkyl phosphonoxy group ($-OPO_3H$(alkyl)) and its conjugated basic group, monoaryl phosphonoxy group ($-OP0_3H$(aryl)) and its conjugated basic group, cyano group, nitro group, dialkyl boryl group ($-B(\text{alkyl})_2$), diaryl boryl group ($-B(\text{aryl})_2$), alkyl aryl boryl group (-B(alkyl)(aryl)), dihydroxy boryl group ($-B(OH)_2$) and its conjugated basic group, alkyl hydroxy boryl group (-B(alkyl)(OH)) and its conjugated basic group, aryl hydroxy boryl group (-B(aryl)(OH)) and its conjugated basic group, aryl group, alkenyl group and alkynyl group.

In the photosensitive composition of the present invention, although it depends on the design of the photosensitive layer, a substituent group having a hydrogen atom capable of hydrogen bonding, particularly a substituent group having acidity whose acid dissociation constant (pKa) is lower than that of carboxylic acid, is not preferable because it tends to deteriorate printing durability. On the other hand, a hydrophobic substituent group such as a halogen atom, a hydrocarbon group (alkyl group, aryl group, alkenyl group, alkynyl group), an alkoxy group and an aryloxy group is preferable because it tends to improve printing durability, and particularly when the cyclic structure is a 6- or less memberred monocyclic aliphatic hydrocarbon such as cyclopentane or cyclohexane, the hydrocarbon preferably has such hydrophobic substituent groups. If possible, these substituent groups may be bound to one another or to a substituted hydrocarbon group to form a ring, and the substituent groups may further be substituted.

When A in formula (i) is $NR^3$-, $R^3$ represents a hydrogen atom or a monovalent hydrocarbon group having 1 to 10 carbon atoms. The monovalent hydrocarbon group having 1 to 10 carbon atoms represented by $R^3$ includes an alkyl group, aryl group, alkenyl group and alkynyl group.

Examples of the alkyl group include a linear, branched or cyclic alkyl group having 1 to 10 carbon atoms such as a methyl group, ethyl group, propyl group, butyl group, pentyl group, hexyl group, heptyl group, octyl group, nonyl group, decyl group, isopropyl group, isobutyl group, sec-butyl group, tert-butyl group, isopentyl group, neopentyl group, 1-methylbutyl group, isohexyl group, 2-ethylhexyl group, 2-methylhexyl group, cyclopentyl group, cyclohexyl group, 1-adamanthyl group and 2-norbornyl group.

Examples of the aryl group include an aryl group having 6 to 10 carbon atoms such as a phenyl group, naphthyl group and indenyl group, and a heteroaryl group having 5 to 10 carbon atoms containing one heteroatom selected from the group consisting of a nitrogen atom, an oxygen atom and a sulfur atom, for example a furyl group, thienyl group, pyrrolyl group, pyridyl group and quinolyl group.

Examples of the alkenyl group include a linear, branched or cyclic alkenyl group having 2 to 10 carbon atoms such as a vinyl group, 1-propenyl group, 1-butenyl group, 1-methyl-1-propenyl group, 1-cyclopentenyl group and 1-cyclohexenyl group.

Examples of the alkynyl group include an alkynyl group having 2 to 10 carbon atoms such as an ethynyl group, 1-propynyl group, 1-butynyl group and 1-octynyl group. Substituent groups which may be possessed by $R^3$ include the same substituent groups as those capable of being introduced into $R^2$. The number of carbon atoms in $R^3$, including the number of carbon atoms in its substituent group, is 1 to 10.

A in the formula (i) is preferably an oxygen atom or -NH- because of easy synthesis.

n in the formula (i) is an integer from 1 to 5, preferably 1 in view of printing durability.

Preferable examples of the repeating unit represented by the formula (i) in the specific binder polymer are shown below, but the present invention is not limited thereto.

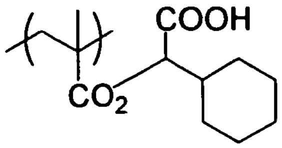

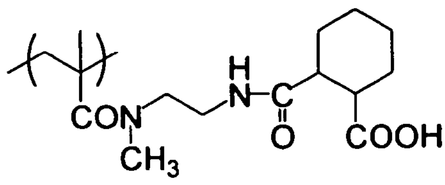

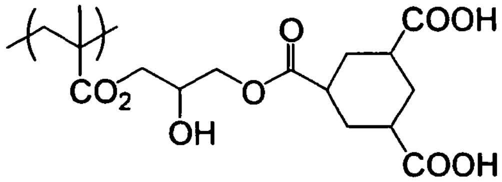

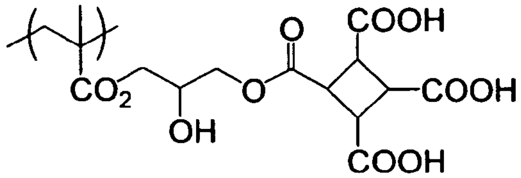

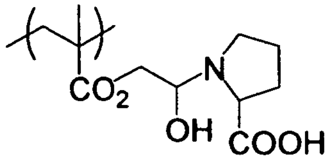

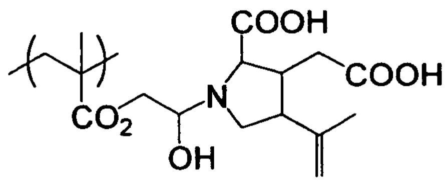

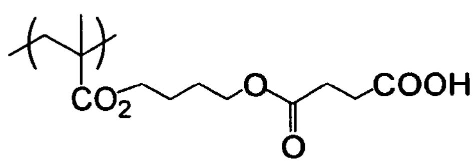

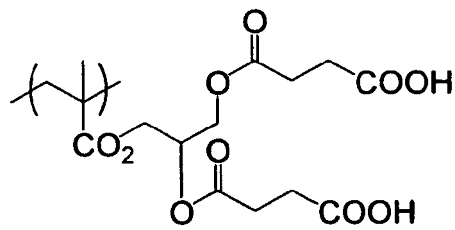

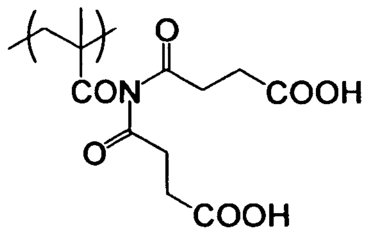

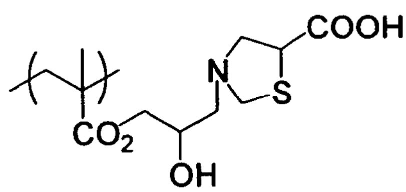

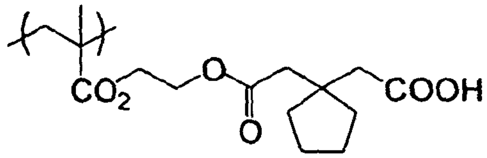

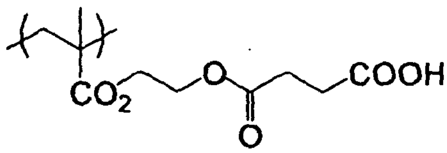

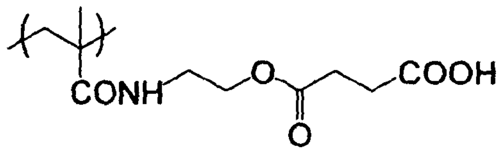

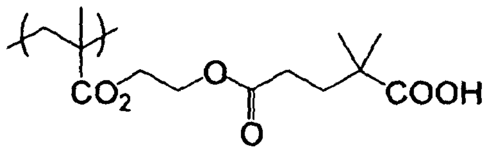

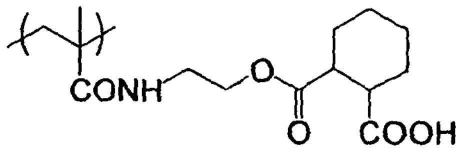

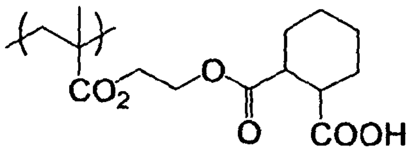

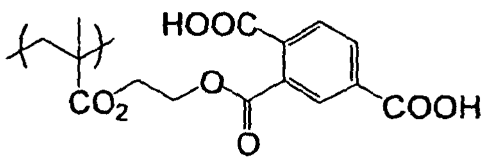

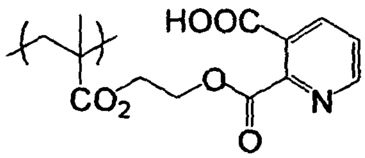

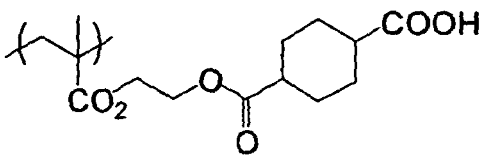

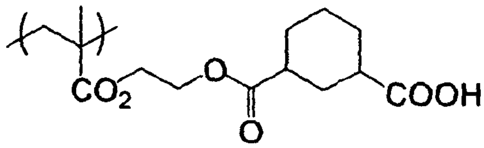

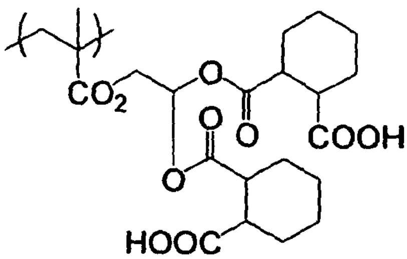

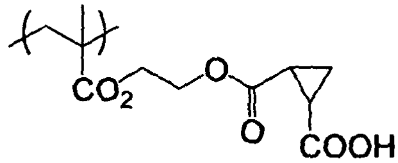

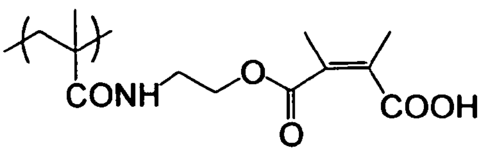

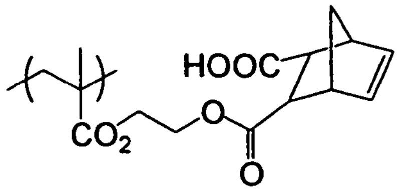

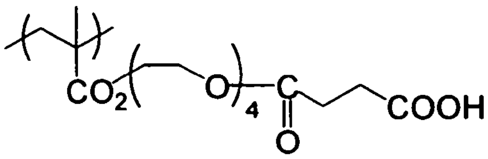

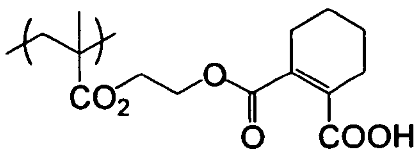

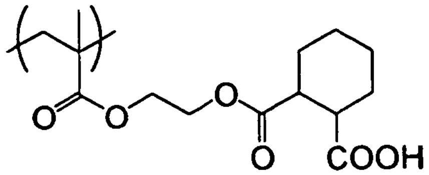

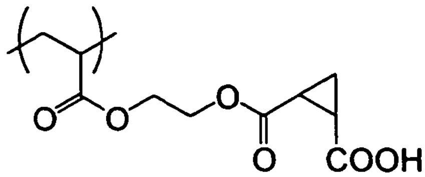

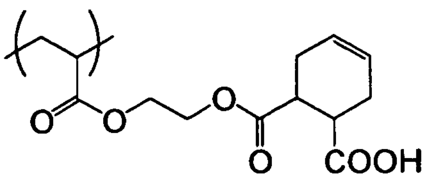

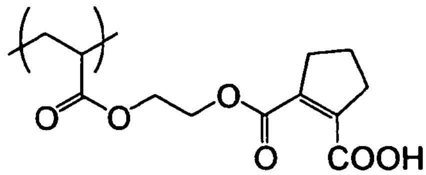

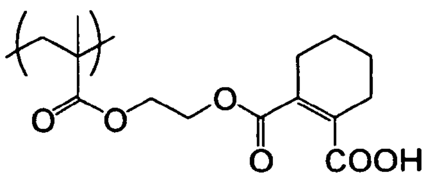

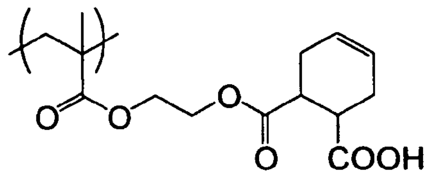

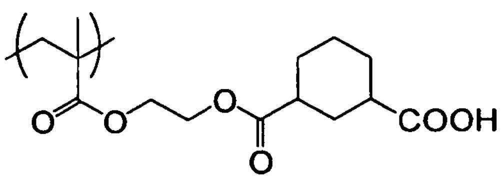

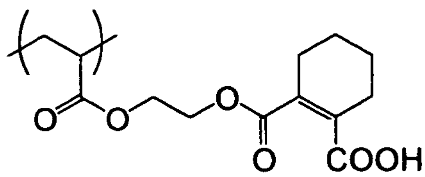

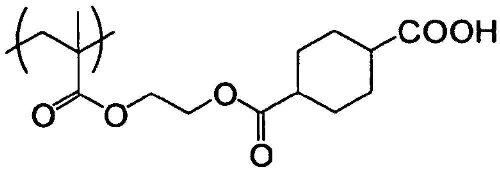
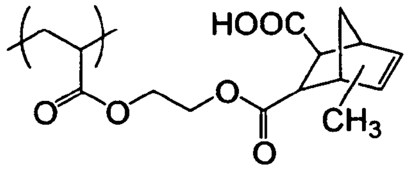

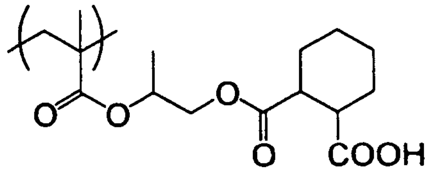
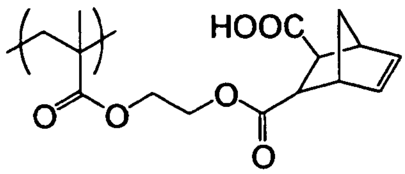

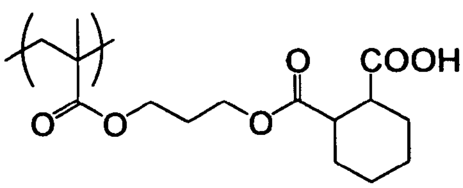
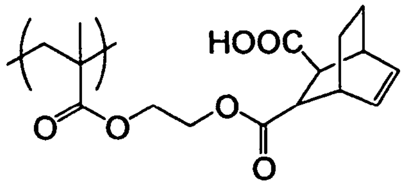

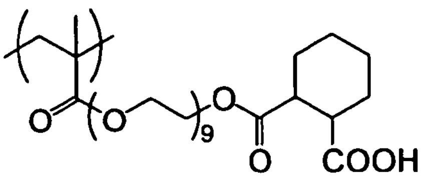
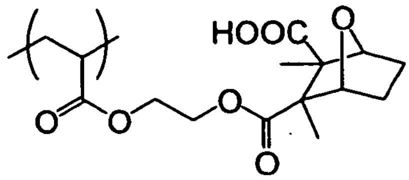

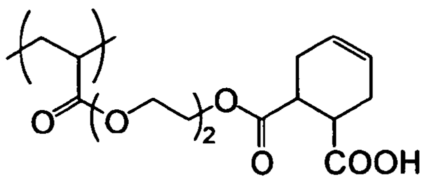
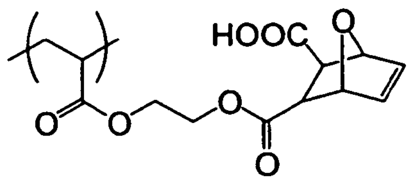

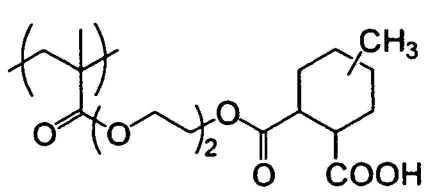
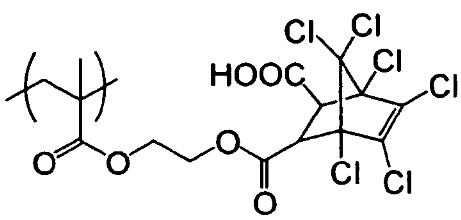

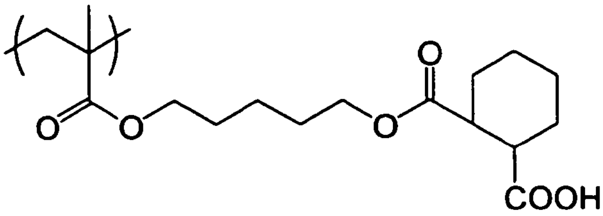

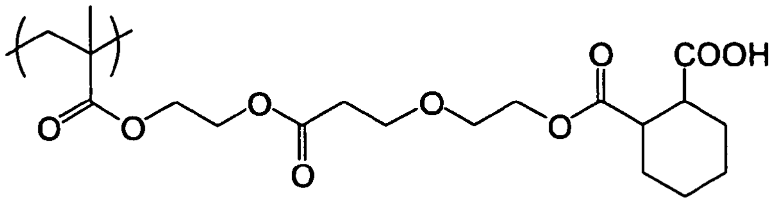

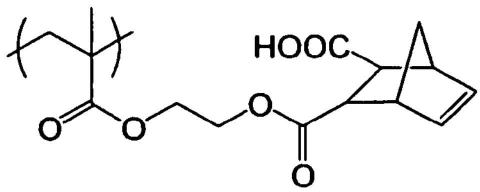

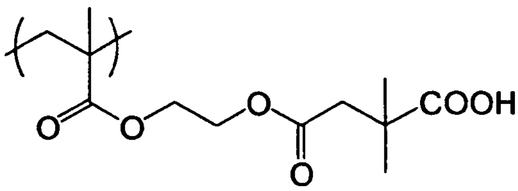

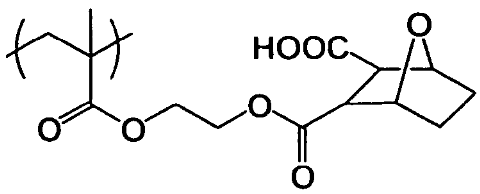

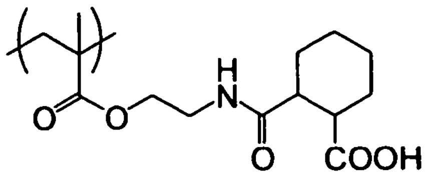

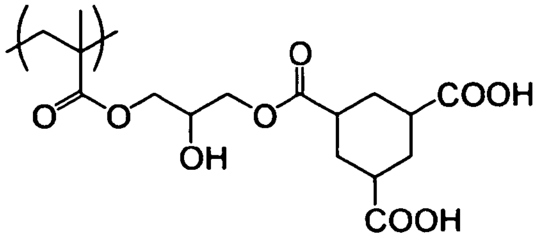

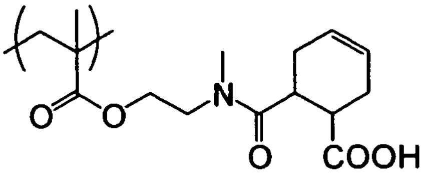

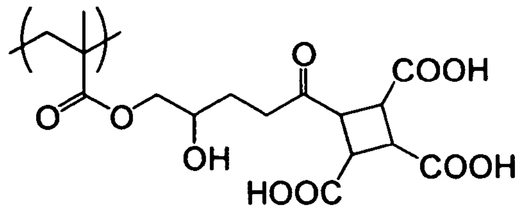

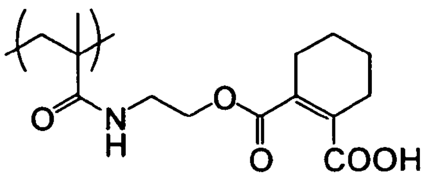

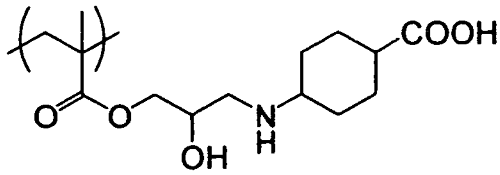

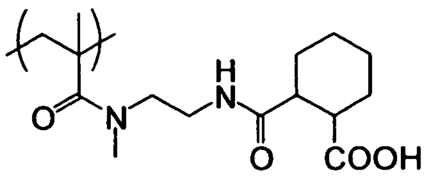

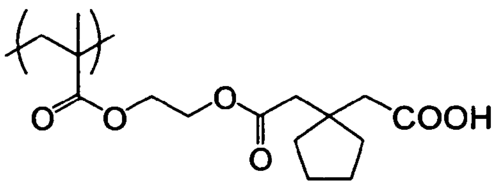

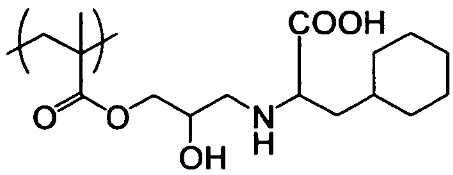

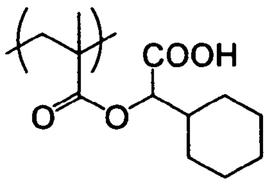

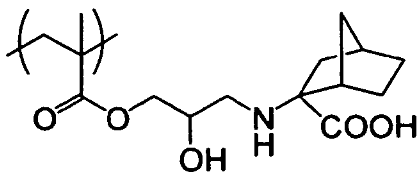

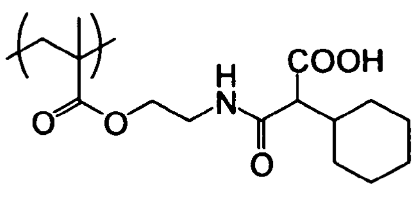

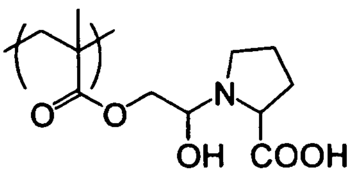

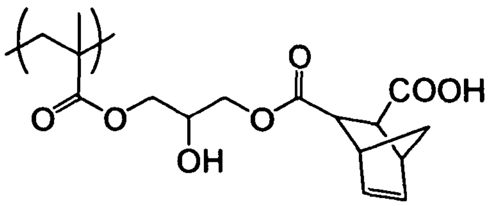

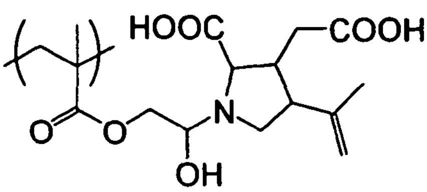

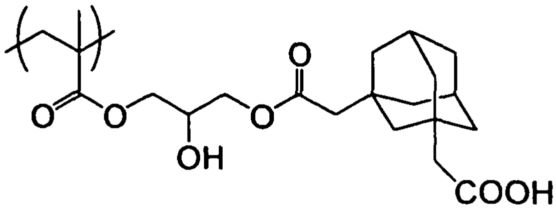

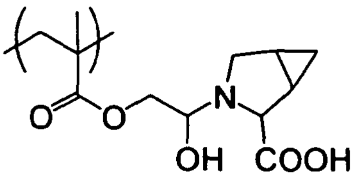

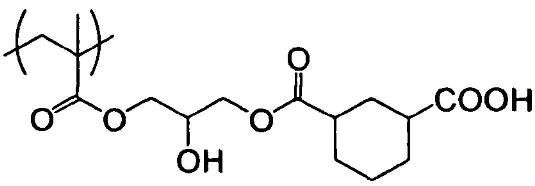

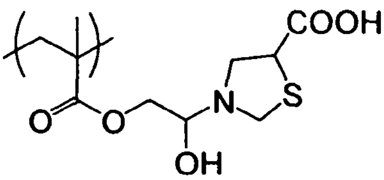

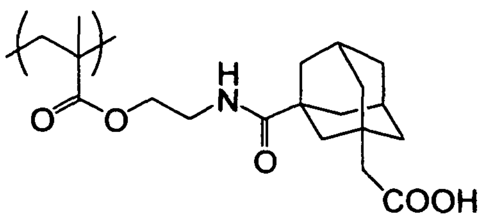

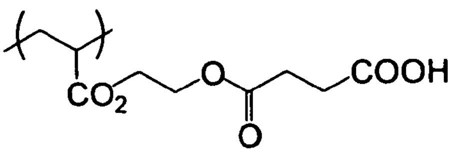

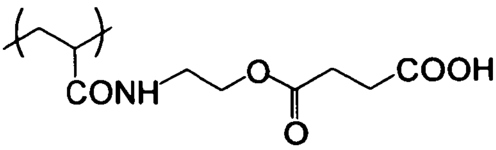

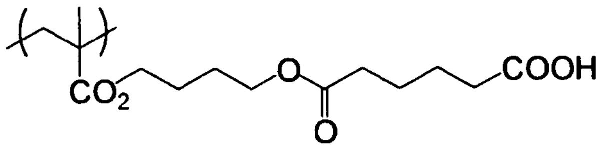

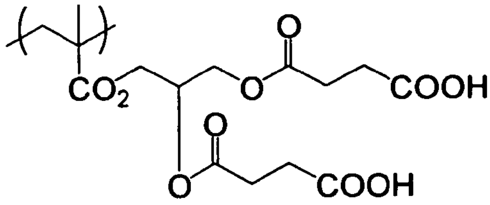

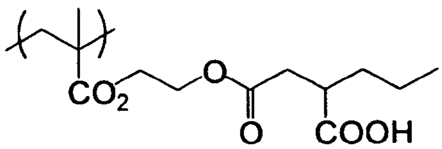

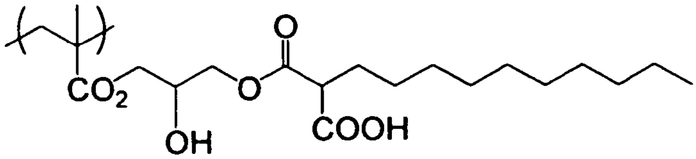

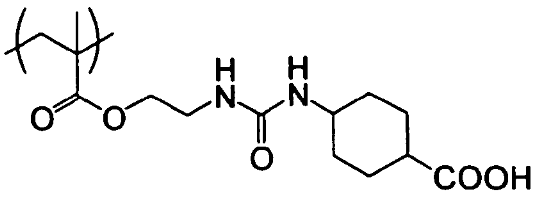

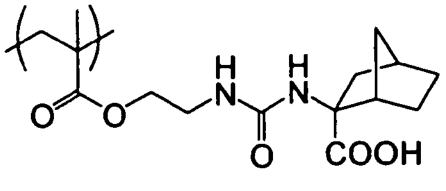

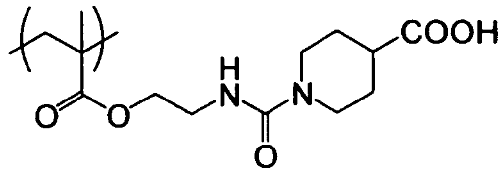

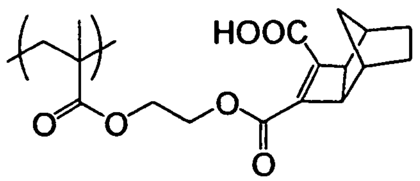

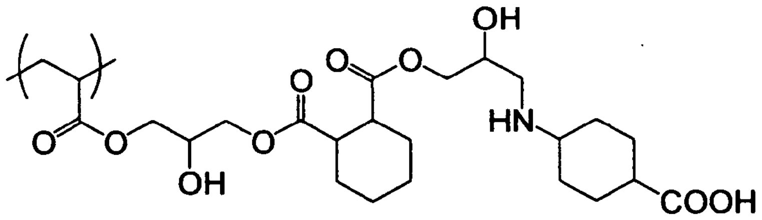

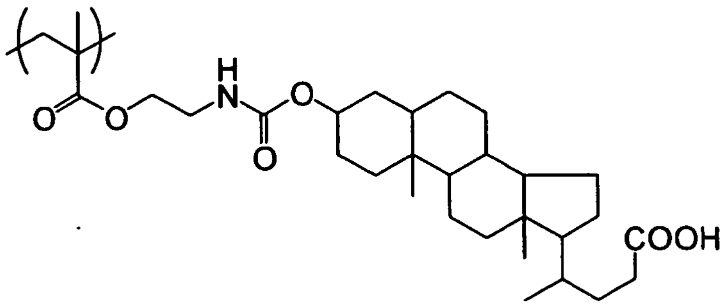

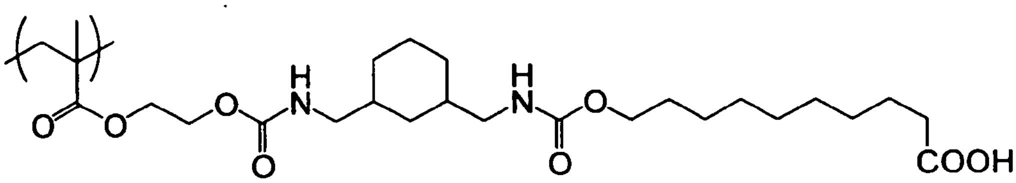

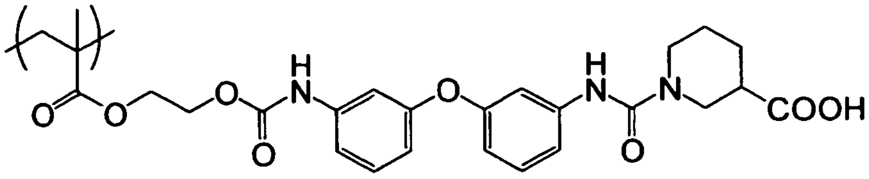

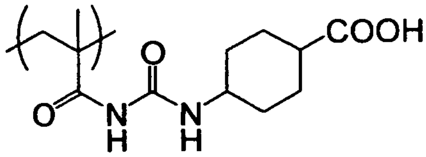

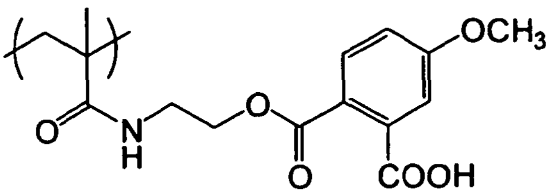

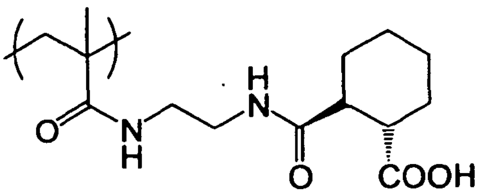

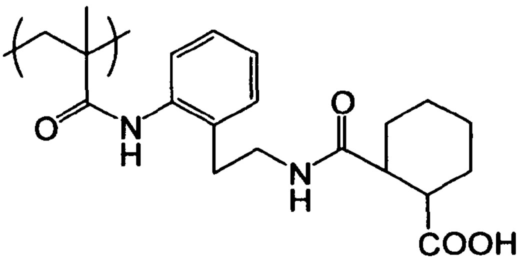

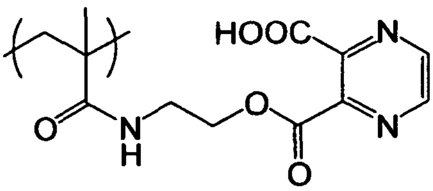

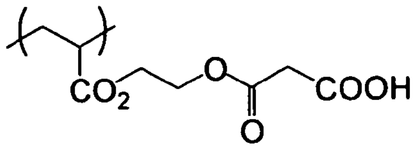

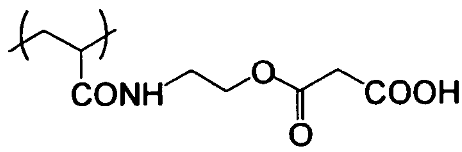

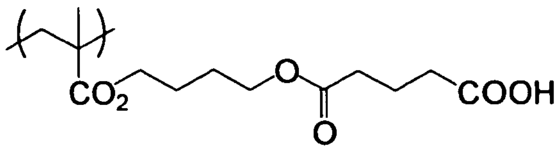

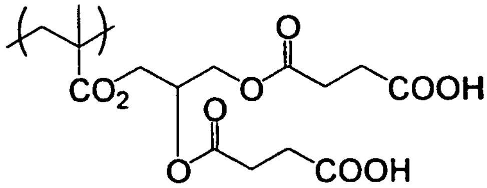

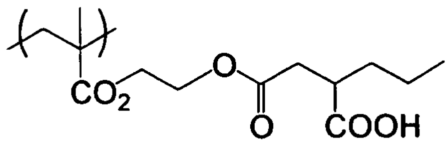

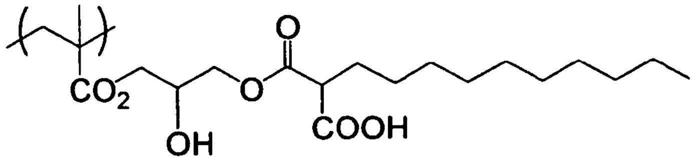

One or two or more kinds of repeating unit represented by the formula (i) may be contained in the binder polymer. The specific binder polymer in the present invention may be a polymer composed exclusively of the repeating unit represented by the formula (i), but is usually used as a copolymer containing other copolymerizable components. The total content of the repeating unit represented by the formula (i) in the copolymer is suitably determined depending on the structure of the copolymer, design of the photosensitive layer, etc., but usually the repeating unit represented by the formula (i) is contained in an amount of 1 to 99% by mole, more preferably 5 to 40% by mole, and still more preferably 5 to 20% by mole, based on the total molar amount of the polymer components.

When a copolymer is used as the binder polymer, copolymerizable components known in the art can be used without limitation insofar as they are radical-polymerizable monomers. Specifically, monomers described in the Polymer Data Handbook -Fundamental Version- compiled by the Society of Polymer Science, Japan and published by Baifukan, 1986 are exemplified. Such copolymerizable components can be used alone or in combination.

The molecular weight of the specific binder polymer in the present invention is suitably determined from the viewpoint of image-forming property and printing durability. The molecular weight is preferably in the range of 2,000 to 1,000,000, more preferably 5,000 to 500,000, and still more preferably 10,000 to 200,000.

As the binder polymer used in the photosensitive layer in the present invention, the specific binder polymer may be used alone, or may be used in combination with one or more other binder polymers. When the specific binder is used, binder polymers used in combination therewith are used in the range of 1 to 60% by mass, preferably 1 to 40%

by mass, and more preferably 1 to 20% by mass, based on the total weight of the binder polymer components. As the binder polymer, any known binder polymers can be used without limitation, and specifically an acrylic main-chain binder and an urethane binder used often in this field are preferably used.

The total amount of the specific binder polymer and binder polymers which can be used in combination therewith in the photosensitive layer composition can be suitably determined, and is usually 10 to 90% by mass, preferably 20 to 80% by mass, and more preferably 30 to 70% by mass, based on the total mass of nonvolatile components in the photosensitive composition.

The acid value (meg/g) of the binder polymer is preferably in the range of 2.00 to 3.60.

- Other binder polymers usable in combination -

The binder polymer which can be used in combination with the specific binder polymer is preferably a binder polymer having a radical-polymerizable group. The radical-polymerizable group is not particularly limited insofar as it can be polymerized with a radical, and examples thereof include α-substituted methyl acryl group [$-OC(=O)-C(-CH_2Z)=CH_2$ wherein Z is a hydrocarbon group starting from a heteroatom], acryl group, methacryl group, allyl group and styryl group, among which an acryl group and methacryl group are preferable.

The content of the radical-polymerizable group in the binder polymer (content of radical-polymerizable unsaturated double bonds determined by iodine titration) is preferably 0.1 to 10.0 mmol, more preferably 1.0 to 7.0 mmol, and most preferably 2.0 to 5.5 mmol, per 1 g of the binder polymer from the viewpoint of sensitivity and storability.

Preferably, the binder polymer further has an alkali-soluble group. The content of the alkali-soluble group (acid value determined by neutralization titration) in the binder polymer is preferably 0.1 to 3.0 mmol, more preferably 0.2 to 2.0 mmol, and most preferably 0.45 to 1.0 mmol, per 1 g of the binder polymer, from the viewpoint of precipitation of development scum and printing durability.

The weight-average molecular weight of the binder polymer is in the range of preferably 2,000 to 1,000,000, more preferably 10,000 to 300,000, and most preferably 20,000 to 200,000, from the viewpoint of film property (printing durability) and solubility in a coating solvent.

The glass transition point (Tg) of the binder polymer is in the range of preferably 70° to 300°C, more preferably 80° to 250°C, and most preferably 90° to 200°C, from the viewpoint of storage stability, printing durability and sensitivity.

As a means of increasing the glass transition point of the binder polymer, its molecule preferably contains an amide group or imide group, and particularly preferably contains methacrylamide derivatives.

(Other component)

In addition to the fundamental components described above, other components suitable for uses, process, etc., can be added to the photosensitive composition of the present invention. Hereinafter, preferable additives are mentioned.

- Colorant -

Dyes or pigments may be added to the photosensitive layer of the present invention for the purpose of coloring. The plate-checking property, that is, the visibility of the printing plate after plate-making and the applicability for image densitometer can thereby be improved when the composition is applied to the printing plate. Examples of the colorant include pigments such as phthalocyanine type pigments, azo type pigments, carbon black and titanium oxide, and dyes such as ethyl violet, crystal violet, azo type dyes, anthraquinone type dyes and cyanine type dyes. Among these colorants, cationic dyes are preferable.

The amount of the dyes and pigments added is preferably about 0.5 to about 5% by mass of nonvolatile components in the entire photosensitive layer composition.

- Polymerization inhibitor -

A small amount of a heat-polymerization inhibitor is preferably added to the photosensitive layer of the present invention in order to inhibit undesired heat polymerization of the polymerizable compound having an ethylenically unsaturated double bond. Preferable examples of the heat-polymerization inhibitor include hydroquinone, p-methoxyphenol, di-t-butyl-p-cresol, pyrogallol, t-butyl catechol, benzoquinone, 4,4'-thiobis(3-methyl-6-t-butyl phenol), 2,2'-methylene bis (4-methyl-6-t-butyl phenol), N-nitrosophenyl hydroxylamine primary cerium salts, etc. The amount of the heat-polymerization inhibitor added is preferably about 0.01 to about 5% by mass relative to the mass of nonvolatile components in the entire composition. To prevent the inhibition of polymerization by oxygen, a higher fatty acid derivative such as behenic acid or behenic amide may be added as necessary so that it is allowed to be locally present on the surface of

the photosensitive layer in the drying step after application. The amount of the higher fatty acid derivative added is preferably about 0.5 to about 10% by mass relative to nonvolatile components in the entire photosensitive layer composition.

- Other additives -

Known additives such as inorganic fillers for improving the physical properties of the cured layer, as well as other plasticizers and sensitizers for improving inking properties on the surface of the photosensitive layer may also be added to the photosensitive layer of the invention. The plasticizers include dioctyl phthalate, didodecyl phthalate, triethylene glycol dicaprylate, dimethyl glycol phthalate, tricresyl phosphate, dioctyl adipate, dibutyl sebacate, triacetyl glycerin, etc., and these can be added in an amount of 10% by mass or less relative to the total mass of the binder polymer and the addition-polymerizable compound.

In the photosensitive layer of the invention, UV initiators and heat-crosslinking agents for enhancing the effect of heating and irradiation after development can also be added for the purpose of improving the layer strength (printing durability) described later.

[Support]

As the support used in the planographic printing plate precursor of the present invention, a known support used in the planographic printing plate precursor can be used without limitation.

The support used in the present invention is preferably a dimensionally stable plate, and examples thereof include paper, paper laminated with plastics (e.g., polyethylene, polypropylene, polystyrene, etc.), a metal plate (e.g., aluminum, zinc, copper, etc.) and plastic film (e.g., cellulose diacetate, cellulose triacetate, cellulose propionate, cellulose butyrate, cellulose butyrate acetate, cellulose nitrate, polyethylene terephthalate, polyethylene, polystyrene, polypropylene, polycarbonate, polyvinyl acetal, etc.), and papers or plastic films having these metals laminated or vapor-deposited thereon. The surface of these supports may be chemically or physically treated, if necessary, in order to impart hydrophilicity thereto, or enhance strength thereof.

Particularly, the support is preferably a paper, a polyester film or an aluminum plate, among which the aluminum plate is particularly preferable because it is excellent in dimensional stability, is relatively inexpensive, can provide a surface excellent in hydrophilicity and strength by surface treatment conducted as necessary. A composite sheet having an aluminum sheet bonded to a polyethylene terephthalate film, as described in JP-B No. 48-18327, is also preferable.

The aluminum plate used as the most preferable support in the invention is a metal plate based on dimensionally stable aluminum, and is selected not only from a pure aluminum plate but also from an alloy plate based on aluminum containing a very small amount of different elements and a plastic film or paper having aluminum (alloy) laminated or vapor-deposited thereon. In the following description, the supports made of aluminum or aluminum alloys are referred to collectively as the aluminum support. The different elements contained in the aluminum alloy include silicon, iron, manganese, copper, magnesium, chromium, zinc, bismuth, nickel, titanium etc. The content of the different elements in the alloy is up to 10% by mass. Particularly preferable aluminum in the present invention is a pure aluminum plate, but because production of absolutely pure aluminum by refining techniques is difficult, aluminum may contain a very small amount of different elements. The composition of the aluminum plate thus used in the present invention is not limited, and any aluminum plates made of a known and conventionally used aluminum material such as JIS A 1050 (commonly-known aluminum material that consists of 99.5% by mass or more of Al), JIS A 1100 (commonly-known aluminum material that consists of 99.0% by mass or more of A1), can be used as necessary.

The thickness of the aluminum support is about 0.1 to 0.6 mm. This thickness can be suitably changed depending on the size of a printing machine, the size of a printing plate, and user's demands.

The aluminum support may or may not be subjected to support surface treatment described later.

(Surface roughening treatment)

The surface roughening treatment includes mechanical roughening, chemical etching and electrolytic grain as disclosed in JP-A No. 56-28893. Use can also be made of an electrochemical surface roughening method for electrochemical surface roughening in a hydrochloric acid or nitric acid electrolyte and mechanical surface roughening methods such as a wire blush grain method of scratching an aluminum surface with a metallic wire, a pole grain method of graining an aluminum surface with abrasive grains ball and an abrasive and a brush grain method of surface roughening with a nylon brush and an abrasive, and these surface roughening methods can be used singly or in combination thereof.. Among these methods, the electrochemical method of chemical surface roughening in a hydrochloric acid or nitric acid electrolyte is particularly useful in surface roughening, and the suitable anodizing electrical quantity is in the range of 50 to 400 $C/dm^2$. Specifically, alternating current and/or direct current electrolysis is conducted preferably at a temperature

of 20 to 80°C, for 1 second to 30 minutes and at a current density of 100 to 400 $C/dm^2$ in an electrolyte containing 0.1 to 50% hydrochloric acid or nitric acid.

The aluminum support thus surface-roughened may be etched chemically with an acid or an alkali. Preferable examples of the etching agent include sodium hydroxide, sodium carbonate, sodium aluminate, sodium metasilicate, sodium phosphate, potassium hydroxide, lithium hydroxide etc., and the concentration and temperature are preferably in the range of 1 to 50% and 20 to 100°C, respectively. After etching, washing with an acid is carried out to remove smuts remaining on the surface. The acid used includes nitric acid, sulfuric acid, phosphoric acid, chromic acid, fluoric acid and borofluoric acid. After electrochemical roughening treatment, the method of removing smuts is preferably a method of contacting with sulfuric acid of 15 to 65% by mass at a temperature of 50 to 90°C as described in JP-A No. 53-12739 and a method of alkali etching as described in JP-B No. 48-28123. The method and conditions are not limited insofar as the central line average roughness Ra of the treated surface after the above-described treatment is 0.2 to 0.5 μm.

(Anodizing treatment)

The thus treated aluminum support having an oxide layer formed thereon is then subjected to anodizing treatment.

In the anodizing treatment, an aqueous solution of sulfuric acid, phosphoric acid, oxalic acid and/or boric acid-sodium borate can be used as the major component in an electrolytic bath. In this case, the electrolyte may contain at least components usually contained in an Al alloy plate, electrode, tap water and underground water. Second and third components may also be contained. The second and third components include, for example, metal ions such as Na, K, Mg, Li, Ca, Ti, Al, V, Cr, Mn, Fe, Co, Ni, Cu and Zn, ammonium ions, and anions such as nitrate ion, carbonate ion, chlorine ion, phosphate ion, fluorine ion, sulfite ion, titanate ion, silicate ion and borate ion, and these may be contained at a concentration of 0 to 10000 ppm. Although the conditions for anodizing treatment are not particularly limited, the plate is treated preferably with 30 to 500 g/L solution at a temperature of 10 to 70°C by direct current or alternating current electrolyte in the range of a current density of 0.1 to 40 $A/m^2$. The thickness of the anodized layer formed is in the range of 0.5 to 1.5 μm. Preferably, the thickness is in the range of 0.5 to 1.0 μm. The treatment conditions should be selected such that the pore diameter of micropores present in the anodized layer formed on the support by the treatment described above is 5 to 10 nm and the pore density is $8 \times 10^{15}$ to $2 \times 10^{16}$ pores/$m^2$.

For treatment for conferring hydrophilicity on the surface of the support, various known methods can be used. The treatment is particularly preferably hydrophilicity-conferring treatment with silicate or polyvinylphosphonic acid. The layer is formed from an Si or P element in an amount of 2 to 40 $mg/m^2$, preferably 4 to 30 $mg/m^2$. The coating amount can be measured by fluorescence X ray analysis.

In the hydrophilicity-conferring treatment, the aluminum support having an anodized layer formed thereon is dipped in an aqueous solution at pH 10 to 13 (determined at 25°C) containing an alkali metal silicate or polyvinylphosphonic acid in an amount of 1 to 30% by mass, more preferably 2 to 15% by mass, for example at 15 to 80°C for 0.5 to 120 seconds.

As the alkali metal silicate used in the hydrophilicization treatment, sodium silicate, potassium silicate, lithium silicate etc. are used. The hydroxide used for raising the pH value of the aqueous alkali metal silicate solution includes sodium hydroxide, potassium hydroxide, lithium hydroxide etc. Alkaline earth metal salts or the group IVB metal salts may be incorporated into the treating solution described above. The alkaline earth metal salts include nitrates such as calcium nitrate, strontium nitrate, magnesium nitrate and barium nitrate, and water-soluble salts such as sulfate, hydrochloride, phosphate, acetate, oxalate and borate. The group IVB metal salts include titanium tetrachloride, titanium trichloride, titanium potassium fluoride, titanium potassium oxalate, titanium sulfate, titanium tetraiodide, zirconium chloride oxide, zirconium dioxide, zirconium oxychloride, zirconium tetrachloride, etc.

The alkaline earth metal salts or the group IVB metal salts can be used singly or in combination thereof. The amount of these metal salts is preferably in the range of 0.01 to 10% by mass, more preferably 0.05 to 5.0% by mass. Silicate electrodeposition as described in US Patent No. 3,658,662 is also effective. A support subjected to electrolytic grain as disclosed in JP-B No. 46-27481, JP-A Nos. 52-58602 and 52-30503, and surface treatment comprising the anodizing treatment in combination with the hydrophilicity-conferring treatment, are also useful.

[Production of the planographic printing plate precursor]

The planographic printing plate precursor of the invention is produced by disposing the photosensitive layer and the protective layer in this order and, as required, an undercoat layer on a support. Such a planographic printing plate precursor may be produced by dissolving each coating solution containing the above various components in a proper solvent and by applying the obtained coating solutions one by one to a support.

When the photosensitive layer is arranged by coating, the components for the photosensitive layer is dissolved in various organic solvents to obtain a photosensitive layer coating solution, and the coating solution is applied onto the

support or the intermediate layer.

The solvent used includes acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetyl acetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxy propanol, methoxy methoxy ethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxy propyl acetate, N,N-dimethyl formamide, dimethyl sulfoxide, γ-butyrolactone, methyl lactate and ethyl lactate. These solvents can be used singly or in combination. The solid content of the photosensitive layer coating solution is suitably 2 to 50% by mass.

The coating amount of the photosensitive layer mainly affects the sensitivity and developability of the photosensitive layer and the strength and printing durability of the layer exposed to light, and is desirably selected depending on the use. When the coating amount is too low, the printing durability is not sufficient. It is not preferable for the coating amount to be too high because sensitivity is reduced, light exposure requires more time, and a longer time is necessary for development processing. The coating amount on the planographic printing plate precursor for scanning light exposure as the major object of the present invention is preferably in the range of about 0.1 to 10 $g/m^2$, and more preferably 0.5 to 5 $g/m^2$, in terms of dried weight.

(Physical Properties of Photosensitive Layer)

The physical properties of the photosensitive layer in the present invention are preferably that the development rate of the light-unexposed region with an alkali developing solution at pH 10 to 13.5 is not less than 80 nm/sec., and the permeation rate of the alkali developing solution into the light-exposed region is not higher than 50 nF/sec.

The development rate of the light-unexposed region with an alkali developing solution at pH 10 to 13.5 is a value obtained by dividing the thickness (nm) of the photosensitive layer by time (sec) necessary for development, and the permeation rate of the alkali developing solution into the light-exposed region is a value indicative of a rate of change, upon dipping in a developing solution, in the electrostatic capacity (F) of the photosensitive layer formed on an electroconductive support.

Hereinafter, the methods of measuring "the development rate of the light-unexposed region with an alkali developing solution" and "the permeation rate of an alkali developing solution into the light-exposed region" are described below.

- Measurement of the development rate of the light-unexposed region with an alkali developing solution -

The development rate of the light-unexposed region of the photosensitive layer with the alkali developing solution is a value obtained by dividing the thickness (nm) of the photosensitive layer by time (sec) necessary for development.

The development rate in the present invention was measured by a DRM interference wave-measuring instrument for measuring the dissolution behavior of a photosensitive layer by dipping an aluminum support provided with a light-unexposed photosensitive layer in a predetermined alkali developing solution (30°C) in the range of pH 10 to 13.5, as shown in Fig. 1. Fig. 1 is an illustration of the DRM interference wave-measuring instrument for measuring the dissolution behavior of a photosensitive layer. In the present invention, the change in the layer thickness was detected by interference with a light of 640 nm. When the development behavior is non-swelling development starting from the surface of the photosensitive layer, the layer thickness is gradually decreased in proportion to the development time to give interference waves depending on the thickness. In the case of swelling dissolution (dissolution to remove the layer), the layer thickness is changed depending on the permeation of the developing solution, thus failing to give beautiful interference waves.

The development time (sec) in which the photosensitive layer is completely removed (i.e., the thickness of the layer becomes 0) under these conditions is then determined, and from this development time (sec) and the thickness (nm) of the photosensitive layer, the development rate can be determined from the equation below. A higher development rate indicates easier removal of the layer with the developing solution, that is, good developability.

$$\text{Development rate (of light-unexposed region)} = [(\text{thickness of photosensitive layer (nm)}/\text{development time (sec)})]$$

- Measurement of the permeation rate of the alkali developing solution into the light-exposed region -

The permeation rate of the alkali developing solution into the light-exposed region is a value indicative of a rate of change, upon dipping in a developing solution, in the electrostatic capacity (F) of the photosensitive layer formed on an electroconductive support.
As shown in Fig. 2, the method of measuring electrostatic capacity as an indicator of permeability in the present invention includes a method wherein a cured photosensitive layer (recording layer in Fig. 2) obtained by light-exposure on an aluminum support used as one electrode and a usual electrode as the other electrode are applied voltage via a conductor wire between the electrodes in a predetermined alkali developing solution (28°C) in the range of pH 10 to 13.5. After applying voltage, the developing solution is permeated into the interface between the support and the photosensitive layer, to change the electrostatic capacity in proportion to the dipping time.
From the time (sec) necessary for the electrostatic capacity to become constant and the saturation value (nF) of the electrostatic capacity of the photosensitive layer, the permeation rate can be determined according to the following equation. A smaller permeation rate is indicative of lower permeability of the developing solution.
Rate of permeation of the developing solution (into light-exposed region) (nF/sec) = (saturation value of the electrostatic capacity of the photosensitive layer (nF)/time (sec) necessary for the electrostatic capacity to become constant)
Regarding the physical properties of the photosensitive layer in the planographic printing plate precursor of the present invention, the development rate of a light-unexposed region with an alkali developing solution at pH 10 to 13.5 is preferably 80 to 400 nm/sec., more preferably 90 to 200 nm/sec, and the rate of permeation of the alkali developing solution into the light-exposed region of the photosensitive layer is preferably 0 to 50 nF/sec., more preferably 0 to 10 nF/sec.
The rate of development of a light-unexposed region of the photosensitive layer and the rate of permeation of the alkali developing solution into the photosensitive layer after curing can be regulated in a usual manner, and typically, addition of a hydrophilic compound is useful for improvement of the rate of development of the light-unexposed region, and addition of a hydrophobic compound is useful for inhibition of permeation of the developing solution into a light-exposed region.
By using the specific binder polymer, the development rate of the photosensitive layer and the permeation rate of the developing solution can be regulated in the preferable ranges described above.

[Intermediate Layer (Undercoat Layer)]

The planographic printing plate precursor of the present invention may include an intermediate layer (undercoat layer) in order to improve adhesiveness between a photosensitive layer and a support and stain resistance. Examples of such intermediate layers include those described in JP-B No. 50-7481, JP-A Nos. 54-72104, 59-101651, 60-149491, 60-232998, 3-56177, 4-282637, 5-16558, 5-246171, 7-159983, 7-314937, 8-202025, 8-320551, 9-34104, 9-236911, 9-269593, 10-69092, 10-115931, 10-161317, 10-260536, 10-282682, 11-84674, 10-069092, 10-115931, 11-038635, 11-038629, 10-282465, 10-301262, 11-024277, 11-109641, 10-319600, 11-084674, 11-327152, 2000-010292, 2000-235254, 2000-352824, and 2001-209170.
As mentioned above, the planographic printing plate precursor of the invention is provided with a protective layer containing a mica compound and a specific polyvinyl alcohol on a polymerizable negative type photosensitive layer.
The planographic printing plate precursor of the invention is superior in resistance to bonding between the photosensitive layer side surface thereof and the support side surface of a planographic printing plate precursor adjacent thereto, so that a laminate can be formed in the condition that no interleaf paper is interposed and it is therefore possible to dispense with the step of removing the interleaf paper in the exposure step in the plate-making process.
Since the planographic printing plate precursor of the invention is improved in the developing removability of the protective layer, the pre-water-washing step can be omitted.
Also, the planographic printing plate precursor of the present invention can form a firm image area at high sensitivity by the aforementioned combination of the photosensitive layer and the protective layer. From this fact, it is also possible to omit the heat-treating step after the exposure step.
These facts shows that the planographic printing plate precursor of the invention can be improved in productivity in plate-making works.

< Plate-making method >

A method of making a planographic printing plate according to the invention will be explained hereinbelow.
The method of making a planographic printing plate according to the invention includes exposing the aforementioned planographic printing plate precursor to light having a wavelength of 750 nm to 1400 nm and then carrying

out development treatment at a conveying speed of 1.25 m/min. or more with substantially no heating treatment and no water-washing treatment.

The method of making a planographic printing plate according to the invention uses the aforementioned planographic printing plate precursor of the invention. Therefore, it enables plate-making without the necessity of heat treatment and water-washing treatment and therefore has such an effect that it has high productivity since it uses the planographic printing plate precursor of the invention.

It is needless to say that this plate-making method is suitable to plate-making of the above planographic printing plate precursor of the invention. However, this plate-making method may be preferably applied to any of planographic printing plate precursors provided with a polymerizable negative type photosensitive layer which contain at least an infrared absorber, a polymerization initiator and a polymerizable compound and is reduced in solubility in an alkali developing solution when exposed to light having a wavelength of 750 nm to 1400 nm. Specifically, any photosensitive layer may be used insofar as it contains all of the "infrared absorber, initiator and polymerizable compound" which are described in the column for explaining each component of the photosensitive layer of the planographic printing plate precursor according to the invention. As the binder polymer, a known one may be compounded or not without any problem.

Also, the photosensitive layer to which the method of making a planographic printing plate according to the invention is applied preferably has the characteristics that the developing speed of the unexposed portion in an alkali developing solution having a pH of 10 to 13.5 is 80 nm/sec or more and the penetration speed of the alkali developing solution at the exposed portion is 50 nF/sec or less. The developing speed of the unexposed portion of the photosensitive layer and the penetration speed of the alkali developing solution in the photosensitive layer after the photosensitive layer is cured may be controlled by a usual method. As typical ones of the control methods, besides the aforementioned method using the specific binder polymer, addition of a hydrophilic compound is useful to improve the developing speed of the unexposed portion and addition of a hydrophobic compound is useful to suppress the penetration of a developing solution into the exposed portion.

[Light Exposure]

Any light source can be used as the light source used in the light exposure, insofar as it can emit light at a wavelength of 750 nm to 1400 nm. Preferable examples thereof include an IR laser. The planographic printing plate precursor of the present invention is preferably imagewizely exposed with infrared ray having a wavelength of 750 nm to 1400 nm emitted by a solid laser or a semiconductor laser. The output power of the laser is preferably 100 mW or more, and a multi-beam laser device is preferably used to reduce the light exposure time. The light exposure time per pixel is preferably within 20 μsec. The energy irradiated on the planographic printing plate precursor is preferably 10 to 300 $mJ/cm^2$. When the energy for light exposure is too low, the curing of the photosensitive layer does not sufficiently proceed. When the energy for light exposure is too high, the photosensitive layer may be ablated with the laser to damage the image.

The light exposure method in the invention can be carried out by overlapping beams from a light source. The term "overlapping" means that the distance between beam centers in the sub-scanning direction is smaller than the beam diameter. For example, when the beam diameter is expressed in terms of full-width half-maximum (FWHM), the overlapping can be quantitatively expressed as FWHM/distance between beam centers in the sub-scanning direction (i.e., overlapping coefficient). The overlapping coefficient in the present invention is preferably 0.1 or more.

The scanning system using a light source in the light exposure device of the present invention is not particularly limited, and known scanning methods such as a drum outer surface scanning method, a drum inner surface scanning method or a flatbed scanning method can be used. The channel of the light source may be single or multi-channel, but in the case of the drum outer surface scanning method, a multi-channel is preferably used.

In the invention, the exposed planographic printing plate precursor is subjected to development treatment without carrying out any particular heat treatment and water-washing treatment as mentioned above. No practice of this heat treatment enables suppression of image non-uniformity caused by the heat treatment. Also, no practice of these heat treatment and water-washing treatment enables stable high-speed treatment in development treatment.

[Development]

In development treatment in the invention, the non-image area of the photosensitive layer is removed using a developing solution.

In the invention, as mentioned above, treating speed in the development treatment, specifically, the conveying speed (line speed) of the planographic printing plate precursor in the development treatment is preferably 1.25 m/min. or more and more preferably 1.35 m/min. or more. The upper limit of the conveying speed is preferably 3 m/min. or less from the viewpoint of conveying stability though no particular limitation is imposed on the conveying speed.

(Developing Solution)

The developing solution used in the invention is preferably an aqueous alkali solution having a pH of 14 or less and more preferably an aqueous alkali solution containing at least one gelation preventive agent selected from mono-alcohol compounds and mono-ketone compounds and an anionic surfactant.

(Mono-alcohol compounds and mono-ketone compounds)

These mono-alcohol compounds and mono-ketone compounds contained in the developing solution used in the invention are monofunctional compounds containing one alcohol or ketone in one molecule. As the mono-alcohol compound or mono-ketone compound used in the invention, compounds having a high-boiling point are preferable because they are scarcely vaporized and their effects are maintained for a long period of time. If these compounds are used, gelation by a water-soluble polymer which is dissolved in the developing solution and originated from the protective layer can be limited.

There is generally a problem that if a gel is produced in a developing solution, the developing solution is deteriorated in developing performance, resulting in the occurrence of stains on the non-image area. There is also the problem that because the presence of a gel in the developing solution causes pipes and spray pipes to be clogged, it is necessary to exchange the processing solution to remove the gel, which reduces working efficiency. If the mono-alcohol compound or mono-ketone compound is used to prevent gelation in the above manner, an operation exchanging the developing solution is unnecessary for a long period of time and it is therefore possible to suppress occurring stains in the non-image area and a reduction in working efficiency.

Specific examples of the mono-alcohol compound and mono-ketone compound include n-propyl alcohol, iso-propyl alcohol, n-butyl alcohol, iso-butyl alcohol, secondary butyl alcohol, tertiary butyl alcohol, n-amyl alcohol, secondary amyl alcohol, tertiary amyl alcohol, cyclohexanol or its derivatives, phenoxyethanol or its derivatives, phenol or its derivatives, diethyl ketone and cyclohexanone or its derivatives.

These compounds may be used either singly or in combinations of two or more. The content of the mono-alcohol and/or mono-ketone in the developing solution is preferably 0.01 to 10 % by mass, more preferably 1 to 8% by mass and still more preferably 2 to 8% by mass.

Also, the developing solution used in the invention preferably contains an aromatic anionic surfactant in addition to the aforementioned mono-alcohol compound and mono-ketone compound.

(Aromatic anionic surfactant)

The aromatic anionic surfactant used in the developing solution in the invention has a development-promoting effect and the effect of stabilizing the dispersion of the components of the polymerizable negative type photosensitive layer and the components of the protective layer and is therefore desirable in view of stabilization of development treatment. Among these compounds, compounds represented by the following formula (A) or (B) are preferable as the aromatic anionic surfactant used in the invention.

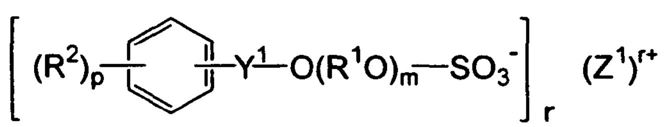

Formula (A)

Formula (B)

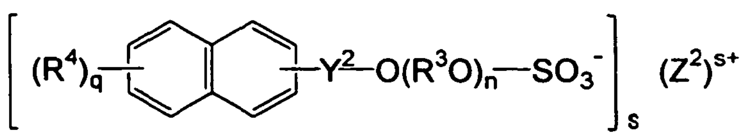

In the formula (A) or (B), $R^1$ and $R^3$ each independently represent a straight-chain or branched alkylene group

having 1 to 5 carbon atoms. Specific examples of the alkylene group include an ethylene group, propylene group, butylene group and pentylene group. Among these groups, an ethylene group and propylene group are particularly preferable.

m and n each independently denote an integer from 1 to 100, preferably 1 to 30 and more preferably 2 to 20. When m is 2 or more, plural $R^3$s may be the same or different. When n is likewise 2 or more, plural $R^5$s may be the same or different.

$R^2$ and $R^4$ each independently represent a straight-chain or branched alkyl group having 1 to 20 carbon atoms. Specific examples of the alkyl group include a methyl group, ethyl group, propyl group, butyl group, hexyl group and dodecyl group. Among these groups, a methyl group, ethyl group, iso-propyl group, n-propyl group, n-butyl group, iso-butyl group and tert-butyl group are particularly preferable.

p and q each independently denote an integer selected from 0 to 2. $Y^1$ and $Y^2$ each independently represent a single bond or an alkylene group having 1 to 10 carbon atoms. Specifically, a single bond, methylene group and ethylene group are preferable and a single bond is particularly preferable.

$(Z^1)^{r+}$ and $(Z^2)^{s+}$ each independently represent an alkali metal ion, an alkali earth metal ion or an unsubstituted ammonium ion or an ammonium ion substituted with an alkyl group. Specific examples of $(Z^1)^{r+}$ or $(Z^2)^{s+}$ include a lithium ion, sodium ion, potassium ion, magnesium ion, calcium ion, ammonium ion and secondary to quaternary ammonium ions substituted with an alkyl group/aryl group having 1 to 20 carbon atoms or an aralkyl group. Particularly, a sodium ion is preferable. r and s each independently denote 1 or 2.

Specific examples of these compounds will be explained hereinbelow: however, these examples are not intended to be limiting of the invention.

K-1

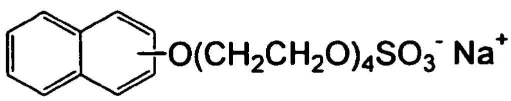

K-2

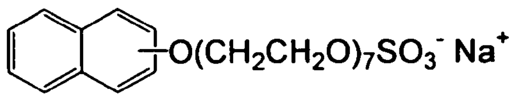

K-3

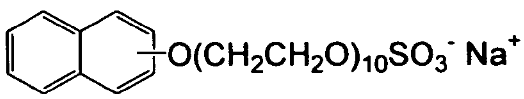

K-4

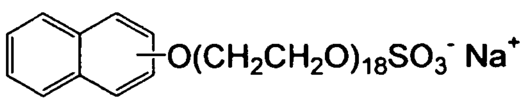

K-5

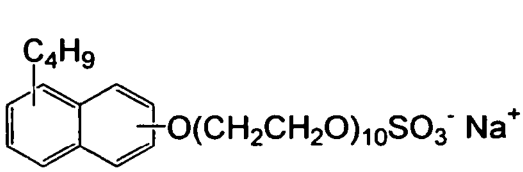

K-6

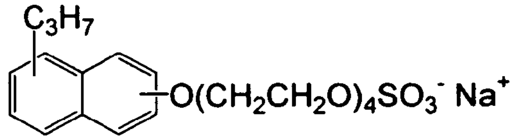

K-7

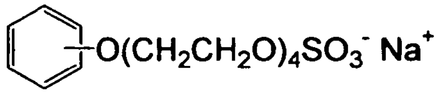

K-8

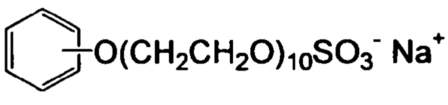

K-9

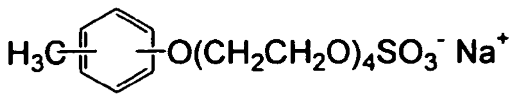

K-10

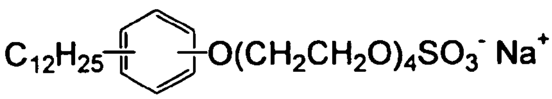

K-11

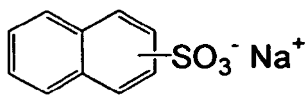

K-12

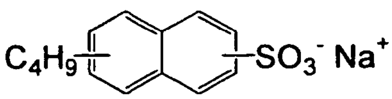

These aromatic anionic surfactants may be used either independently or in combinations of two or more. As to the amount of the aromatic anionic surfactant, it is effective to design the amount of the surfactant to be preferably in a range from 1.0 to 10% by mass and more preferably in a range from 2 to 10% by mass. Here, if the content of the surfactant is less than 1.0% by mass, this brings about reductions in developing characteristics and the solubility of the photosensitive layer component. If the content is 10% by mass or more, the printing durability of the printing plate is reduced.

The developing solution according to the invention may use, in addition to the above aromatic anionic surfactant, other surfactants together. Given as examples of these other surfactants are nonionic surfactants including polyoxyethylene alkyl ethers such as polyoxyethylene naphthyl ether, polyoxyethylene alkylphenyl ether, polyoxyethylene lauryl ether, polyoxyethylene cetyl ether and polyoxyethylene stearyl ether, polyoxyethylene alkyl esters such as polyoxyethylene stearate, sorbitan alkyl esters such as sorbitan monolaurate, sorbitan monostearate, sorbitan distearate, sorbitan monooleate, sorbitan sesquioleate and sorbitan trioleate and monoglyceride alkyl esters such as glycerol monostearate and glycerol monooleate.

The content of these other surfactants in the developing solution is 0.1 to 10% by mass based on the amount of effective components.

(Chelating agent for divalent metals)

The developing solution according to the invention is preferably made to contain a chelating agent for a divalent metal with the intention to suppress the influences of, for example, calcium ions contained in hard water. Examples of the chelating agent for a divalent metal include polyphosphates such as $Na_2P_2O_7$, $Na_5P_3O_3$, $Na_3P_3O_9$, $Na_2O_4P$ $(NaO_3P)$ $PO_3Na_2$ and Calgon (sodium polymethaphosphate); aminopolycarboxylic acids such as ethylenediaminetetraacetic acid and its potassium salts, sodium salts and amine salts, diethylenetriaminepentaacetic acid and its potassium salts and sodium salts, triethylenetetraminehexaacetic acid and its potassium salts and sodium salts, hydroxyethylethylenediaminetriacetic acid and its potassium salts and sodium salts, nitrilotriacetic acid and its potassium salts and sodium salts, 1,2-diaminocyclohexanetetraacetic acetic acid and its potassium salts and sodium salts, and 1,3-diamino-2-propanoltetraacetic acid and its potassium salts and sodium salts; and organic phosphonic acids such as 2-phosphono-1,2,4-butanetricarboxylic acid and its potassium salts and sodium salts, 2-phosphono-2,3,4-butanetricarboxylic acid and its potassium salts and sodium salts, 1-phosphono-1,2,2-ethanetricarboxylic acid and its potassium salts and sodium salts, 1-hydroxyethane-1,1-diphosphonic acid and its potassium salts and sodium salts, and aminotri(methylenephosphonic acid) and its potassium salts and sodium salts. Among these compounds, ethylenediaminetetraacetic acid and its potassium salts, sodium salts and amine salts, ethylenediaminetetra(methylenephosphonic acid) and its ammonium salts and potassium salts; and hexamethylenediaminetetra(methylenephosphonic acid) and its ammonium salts and potassium salts are preferable.

The optimum amount of the chelating agent varies corresponding to the hardness and amount of hard water to be used. However, the chelating agent is contained in an amount of generally 0.01 to 5% by mass and preferably 0.01 to 0.5% by mass in the developing solution during use.

Also, alkali metal salts of organic acids or inorganic acids may be added as developing regulators to the developing solution according to the invention. For example, sodium carbonate, potassium carbonate, ammonium carbonate, sodium citrate, potassium citrate and ammonium citrate may be used singly or in combinations of two or more.

(Alkali agent)

Examples of the alkali agent used in the developing solution according to the invention include inorganic alkali agents such as sodium tertiary phosphate, potassium tertiary phosphate, ammonium tertiary phosphate, sodium borate, potassium borate, ammonium borate, sodium hydroxide, potassium hydroxide, ammonium hydroxide and lithium hydroxide and organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine and tetramethylammoniumhydroxide. In the invention, these compounds may be used either singly or in combinations of two or more.

Also, examples of alkali agents other than the above agents may include alkali silicates. These alkali silicates may be used in combination with a base. Examples of the alkali silicates to be used are those exhibiting alkalinity when dissolved in water and include sodium silicate, potassium silicate, lithium silicate and ammonium silicate. These silicates may be used either singly or in combinations of two or more.

The developing solution used in the invention may be easily adjusted to an optimum range by controlling the mixing ratio of silicon oxide $SiO_2$ which is a component of silicate (silicate is a component to impart hydrophilicity to the support) to an alkali oxide $M_2O$ (M represents an alkali metal or an ammonium group) which is an alkali component, and the concentrations of these components. The mixing ratio (molar ratio of $SiO_2/M_2O$) of silicon oxide $SiO_2$ to an alkali oxide $M_2O$ is preferably in a range from 0.75 to 4.0 and more preferably in a range from 0.75 to 3.5 from the viewpoint of suppressing the occurrence of stains caused by excess dissolution (etching) of an anodic oxide film of the support and generation of insoluble gas caused by the formation of a complex of dissolved aluminum and a silicate.

Also, the concentration of the alkali silicate in a developing solution is preferably in a range from 0.01 to 1 mol/L and more preferably in a range from 0.05 to 0.8 mol/L as the amount of $SiO_2$ based on the mass of the developing solution from the viewpoint of the effect of suppressing dissolution (etching) of an anodic oxide film of the support, developing ability, the effect of suppressing precipitation and generation of crystals and the effect of preventing gelation when developing solution waste is neutralized.

The developing solution used in the invention may use the following components together according to the need besides the above components. Examples of these components include organic carboxylic acids such as benzoic acid, phthalic acid, p-ethylbenzoic acid, p-n-propylbenzoic acid, p-isopropylbenzoic acid, p-n-butylbenzoic acid, p-t-butylbenzoic acid, p-2-hydroxyethylbenzoic acid, decanoic acid, salicylic acid and 3-hydroxy-2-naphthoic acid; organic

solvents such as propylene glycol; and others including reducing agents, dyes, pigments, water softeners and antiseptics.

The developing solution used in the invention has a pH in a range from preferably 10 to 12.5 and more preferably 11 to 12.5 at 25°C. Since the developing solution of the invention contains the aforementioned surfactant, excellent developing characteristics are developed in the non-image arae even if a developing solution having such low pH is used. Such a measures as to make the developing solution have a lower pH reduces damages to the image area during developing and improves the handling characteristics of the developing solution.

Also, the conductivity x of the developing solution preferably satisfies the equation $2 < x < 30$ mS/cm and is more preferably 5 to 25 mS/cm.

Here, it is preferable to add alkali metal salts of organic acids or inorganic acids as conductive regulators that regulate conductivity.

The above developing solution may be used as a developing solution for an exposed planographic printing plate precursor and as a developing replenishing solution and is preferably applied to an automatic developing machine. In the case of carrying out developing using an automatic developing machine, the developing solution is exhausted corresponding to the throughput and a replenishing or fresh developing solution may be therefore used to recover developing capability. This replenishing system is also preferably applied in the plate-making method of the invention.

In order to recover the developing capability of the developing solution by using an automatic developing machine, it is preferable to replenish using a method as described in U.S.Patent No. 4,882,246. Developing solutions as described in each publication of JP-A Nos. 50-26601 and 58-54341 and JP-B Nos. 56-39464, 56-42860 and 57-7427 are also preferable.

The planographic printing plate precursor developed in this manner is subjected to after-treatment performed using rinsing water, a rinsing solution containing surfactants and the like and a protective gum solution containing gum arabic and a starch derivative as its major components. For the after-treatment of the planographic printing plate precursor of the present invention, these treatments are used in various combinations. The planographic printing plate obtained by such treatments is placed in an offset printer and used for printing a number of copies.

In the method of making a planographic printing plate according to the invention, the developed image may be subjected to after-heating treatment and exposure performed on the entire surface for the purpose of improving image strength and printing durability.

Very strong conditions can be utilized in the heating after the image is developed. The heating is usually carried out at a temperature in a range from 200 to 500°C. If the heating temperature after the development treatment is too low, only an insufficient image strengthening effect is obtained whereas if the heating temperature is too high, there is fears of a deterioration of the support and thermal decomposition of the image area.

The planographic printing plate obtained by such treatments is placed in an offset printer and used for printing a number of copies.

As the plate cleaner used to remove stains on the plate during printing, a conventionally known plate cleaner for PS plate is used. Examples of the plate cleaner include CL-1, CL-2, CP, CN-4, CN, CG-1, PC-1, SR and IC (manufactured by Fuji Photo Film Co., Ltd.).

## EXAMPLES

The present invention will be explained in more detail by way of examples, which, however, should not be construed to limit the scope of the invention.

### Example 1

(Production of a support)

A 0.30-mm-thick and 1030-mm-wide JIS A1050 aluminum plate was used to carry out the following surface treatment.

< Surface treatment >

In the surface treatment, the following various treatments (a) to (f) were continuously carried out. After each treatment and washing, a nip roller was used to drain off.

(a) The aluminum plate was subjected to etching treatment carried out in the following condition: concentration of caustic soda: 26% by mass, concentration of ammonium ions: 6.5% by mass and temperature: 70°C, to dissolve 5 $g/m^2$ of the aluminum plate, followed by washing with water.

(b) The aluminum plate was subjected to desmatting treatment carried out using an aqueous 1 mass % nitric acid

solution (including 0.5% by mass of aluminum ions) kept at 30°C by spraying, followed by washing with water.

(c) The aluminum plate was subjected to electrochemical surface roughing treatment carried out continuously by using 60 Hz a.c. current. The electrolytic solution used at this time was an aqueous 1 mass % nitric acid solution (including 0.5% by mass of aluminum ions and 0.07 % by mass of ammonium ions) kept at 30°C. Electrochemical surface roughening treatment was carried out by using an a.c. power source with a trapezoidal rectangular wave a.c. current having the following characteristics: the time TP required for the current to reach a peak from zero: 2 msec and duty ratio: 1 : 1 and also using a carbon electrode as the counter electrode. Ferrite was used as the auxiliary anode. The current density was 25 $A/dm^2$ when the current reached a peak and the quantity of electricity was 250 $C/cm^2$ as the sum of the quantity of electricity when the aluminum plate served as the anode. 5% of the current flowing from the power source was distributed to the auxiliary anode and then the aluminum plate was washed with water.

(d) The aluminum plate was subjected to etching treatment carried out by spraying in the following condition: concentration of caustic soda: 26% by mass, concentration of ammonium ions: 6.5% by mass and temperature: 35°C, to dissolve 0.2 $g/m^2$ of the aluminum plate, to thereby remove the smut component which was produced when the electrochemical surface roughening treatment using a.c. current in the previous stage and primarily contained aluminum hydroxide and to dissolve the edge part of the generated pit, thereby smoothing the edge part. Then, the aluminum plate was washed with water.

(e) The aluminum plate was subjected to desmatting treatment carried out using an aqueous 25 mass % sulfuric acid solution (including 0.5% by mass of aluminum ions) kept at 60°C by spraying, followed by washing with water.

(f) The aluminum plate was subjected to anodic oxidation treatment in the following condition: concentration of sulfuric acid: 170 g/l (containing 0.5% by mass of aluminum ions), temperature: 33°C and current density: 5 ($A/dm^2$), for 50 seconds, followed by washing with water. The weight of the anodic oxide film at this time was 2.7 $g/m^2$.

The surface roughness Ra of the aluminum support obtained in this manner was 0.27 (measuring device: SURFCOM, manufactured by TOKYO SEIMITSU Co., Ltd., diameter of the tracer head: 2 mμ).

< Undercoat layer >

Next, the following undercoat layer coating solution was applied to this aluminum support by using a wire bar and dried at 90°C for 30 minutes. The amount applied was 10 $mg/m^2$.

(Undercoat layer coating solution)

- High-molecular compound A having the following structure 0.05 g
- Methanol 27 g
- Ion exchange water 3 g

HIGH-MOLECULAR WEIGHT COMPOUND A

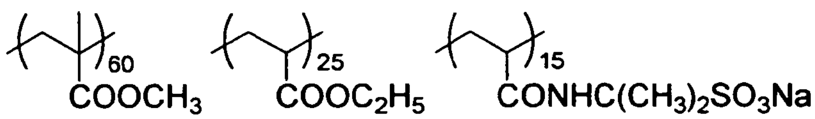

(Photosensitive layer)

Next, the following photosensitive layer coating solution (P-1) was prepared and applied to the foregoing aluminum support by using a wire bar. A drying operation was carried out at 115°C for 34 seconds in a hot air drier to obtain a planographic printing plate. The coating amount after the film was dried was 1.3 $g/m^2$.

< Photosensitive layer coating solution (P-1) >

- Infrared absorber (IR-1) 0.074 g
- Photopolymerization initiator (OS-12) 0.280 g
- Additive (PM-1) 0.151 g
- Polymerizable compound (AM-1) 1.00 g
- Specific binder polymer (BT-1) 1.00 g
- Ethyl violet (C-1) 0.04 g
- Fluoro-surfactant (MEGAFACE F-780-F, manufactured by Dainippon Ink and Chemicals, Incorporated, methyl isobutyl ketone (MIBK) 30 % by mass solution) 0.015 g
- Methyl ethyl ketone 10.4 g
- Methanol 4.83 g
- 1-Methoxy-2-propanol 10.4 g

The photopolymerization initiator (OS-12) used in the above photosensitive layer coating solution indicates a compound given as the examples of the onium salt represented by the formula (1). Also, each structure of the aforementioned infrared absorber (IR-1), additive (PM-1), polymerizable compound (AM-1), binder polymer (BT-1) and Ethyl Violet (C-1) is shown below.

(IR-1)

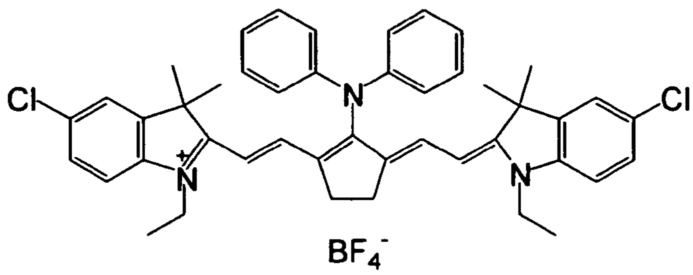

(PM-1)

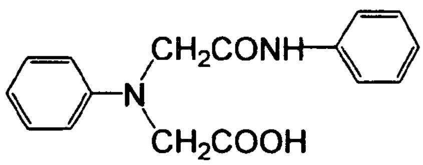

(AM-1)

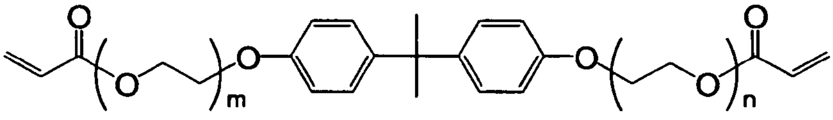

m+n=4

(BT-1)

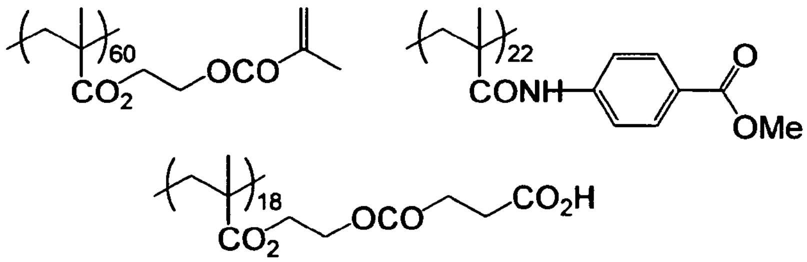

(C-1)

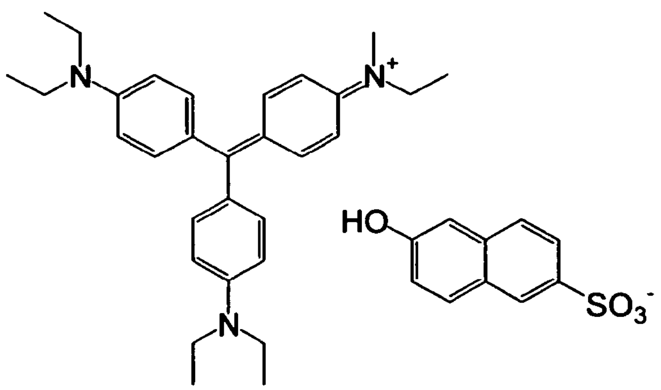

(Protective layer)

(1) Preparation of a dispersion solution of a mica compound

6.4 g of synthetic mica (trade name: SOMASIF ME-100, manufactured by Cope Chemical, aspect ratio: 1000 or more) was added to 193.6 g of water and dispersed until the average particle diameter (circle equivalent diameter) was 3pm (laser scattering method) to obtain a mica dispersion solution.

(2) Application of a protective layer coating solution

An aqueous mixture solution (protective layer coating solution) of the obtained mica dispersion solution, a specific polyvinyl alcohol (trade name: PVA-203, manufactured by Kuraray Co., Ltd., saponification value: 88 mol%, degree of polymerization: 300), a copolymer of polyvinyl pyrrolidone and vinyl acetate (trade name: LUVITEC VA64W, manufactured by ICP, polyvinyl pyrrolidone/vinyl acetate = 6/4) and a surfactant (trade name: Emalex 710) was applied to the surface of the foregoing photosensitive layer by a wire bar and dried at 125°C for 75 seconds in a hot air type drier.

The ratio of solid content of mica/specific polyvinyl alcohol/copolymer of polyvinyl pyrrolidone and vinyl acetate/surfactant in this aqueous mixture solution was 16/80/2/2 (% by mass) and the total coating amount (coating amount after dried) was 1.15 g/m$^2$.

Thus, a planographic printing plate precursor of Example 1 was obtained. Examples 2 to 11

Planographic printing plate precursors of Examples 2 to 11 were obtained in the same manner as in Example 1 except that the type and content of the mica compound, the type of the binder component (specific polyvinyl alcohol)

and the total coating amount were altered to those shown in the following Table 1 in the composition of the aqueous mixture solution (protective layer coating solution) of Example 1. In the case of altering the content of the mica compound, this content was adjusted by the content of the copolymer of polyvinyl pyrrolidone and vinyl acetate.

Comparative Example 1

A planographic printing plate precursor of Comparative Example 1 was obtained in the same manner as in Example 1 except that, in the aqueous mixture solution (protective layer coating solution) of Example 1, the binder component was altered to PVA-105 (trade name, manufactured by Kuraray Co., Ltd., saponification value: 98.5 mol%) from PVA-203 and the composition was altered such that the ratio of PVA-105/copolymer of polyvinyl pyrrolidone and vinyl acetate/surfactant was 78/20/2 (% by mass) and the total coating amount (coating amount after dried) was altered to 2.00 g/$m^2$.

Comparative Example 2

A planographic printing plate precursor of Comparative Example 2 was obtained in the same manner as in Example 1 except that, in the aqueous mixture solution (protective layer coating solution) of Example 1, the binder component was altered to an acid-modified polyvinyl alcohol (trade name: KL-506, manufactured by Kuraray Co., Ltd., saponification value: 77 mol%) from PVA-203 and the composition was altered such that the ratio of KL-506/copolymer of polyvinyl pyrrolidone and vinyl acetate/surfactant was 96/2/2 (% by mass) and the total coating amount (coating amount after dried) was altered to 1.00 g/$m^2$.

Evaluation

(1) Evaluation of sensitivity

The obtained planographic printing plate precursor was exposed to light in TRENDSETTER 3244 (trade name, manufactured by Creo) in the following condition: resolution: 2400 dpi and rotation of the outside surface drum: 150 rpm, with varying a power in steps of 0.15 as log E in a power range from 0 to 8 W. The precursor was exposed to light in the condition of 25°C and 50% RH. After exposed to light, the precursor was developed at a developing temperature of 30°C at a conveying speed (line speed) of 2 m/min. in an automatic developing machine LP-1310HII manufacture by Fuji Photo Film Co., Ltd. without carrying out heating treatment and water-washing treatment. DH-N diluted with water (1 : 4) was used as the developing solution and GN-2K (trade name, manufactured by Fuji Photo Film Co., Ltd.) diluted with water (1 : 1) was used as the finisher.

As to the density of the image area of the planographic printing plate obtained after developed, cyan density was measured using a Macbeth reflection densitometer RD-918 and a red filter set to the densitometer. The inverse of the exposure amount necessary to obtain a cyan density of 0.8 is defined as an index of sensitivity. In the results of evaluation, the sensitivity of the planographic printing plate obtained in Comparative Example 1 was set to 100 to rate each sensitivity of other planographic printing plates relatively. The larger the value is, the higher the sensitivity is. The results are shown in Table 1.

(2) Evaluation of image quality

80% screen tint image on the obtained planographic printing plate precursor was exposed to light in TRENDSETTER 3244 (trade name, manufactured by Creo) in the following condition: resolution: 2400 dpi, power: 7 W, rotation of the outside surface drum: 150 rpm and energy on the plate: 110 mJ/$cm^2$. After exposed to light, the precursor was developed in the same manner as in the above evaluation of sensitivity. The screen tint unevenness of the resulting planographic printing plate was visually evaluated. Each plate was functionally evaluated according to rates 1 to 5, where the rate 3 was a practically allowable lower limit and the rate 2 or less was a practically unallowable level.

(3) Evaluation of printing performances

The planographic printing plate used in (2) Evaluation of image quality is subjected to printing carried out using a printer (trade name: Lithron, manufactured by Komori Corporation (k.k.) to evaluate the degree of stains in the non-image area and printing durability. The stains in the non-image area were functionally evaluated according to rates 1 to 5, where the rate 3 is a practically allowable lower limit and the rate 2 or less is a practically unallowable level.

(4) Evaluation of bonding resistance

The humidity of the obtained three planographic printing plate precursors (10 X 10 cm) was controlled under a circumstance of 25°C and 75% RH for 2 hours and then, these three precursors were laminated one by one in the same directions in such a condition that no interleaf paper was interposed therebetween. This laminate was sealed in a package of A 1 kraft paper and allowed to stand at 30°C for 5 days under a load of 4 kg. The resulting laminate was evaluated as to the state of adhesion between the photosensitive layer side surface (protective layer surface) of one planographic printing plate precursor and the support side surface of another planographic printing plate precursor adjacent to the one planographic printing plate precursor. The bonding resistance was functionally evaluated according to rates 1 to 5, where the rate 3 was a practically allowable lower limit and the rate 2 or less was a practically unallowable level.

(5) Evaluation of soiling in the developing tank

Using a planographic printing plate precursor exposed to light in the same manner as in the above (2) Evaluation of image quality, the planographic printing plate precursor was developed in a quantity equivalent to 3000 $m^2$ in 45 L of a developing solution. Then, the developing solution was discharged to observe soiling in the developing solution tank visually. The soiling was functionally evaluated according to rates 1 to 5, where the rate 3 is a practically allowable lower limit and the rate 2 or less is a practically unallowable level.

The results of the above tests are shown in Table 1.

Table 1

| | Protective layer | | | | Results of evaluation | | | | | |
|---|---|---|---|---|---|---|---|---|---|---|
| | Inorganic layered compound | | Binder component | Whole coating amount (g/m$^2$) | Sensitivity | Image quality | Printing performance | | Bonding resistance | Soiling in the developing solution tank |
| | Type | Content (% by mass) | | | | | Stains in the non-image area | Printing durability (10$^4$ copies) | | |
| Example 1 | SOMASIF ME-100 | 3 | PVA-203 | 1.15 | 90 | 5 | 5 | 14 | 3 | 4 |
| Example 2 | SOMASIF ME-100 | 16 | PVA-203 | 0.50 | 90 | 4 | 5 | 12 | 4 | 5 |
| Example 3 | SOMASIF F ME-100 | 16 | PVA-203 | 1.15 | 100 | 5 | 5 | 15 | 4 | 4 |
| Example 4 | SOMASIF ME-100 | 10 | PVA-203 | 1.15 | 95 | 5 | 5 | 14 | 4 | 4 |
| Example 5 | SOMASIF ME-100 | 25 | PVA-203 | 1.15 | 100 | 5 | 5 | 15 | 5 | 4 |
| Example 6 | Micromica MK-100*1 | 10 | PVA-203 | 1.50 | 100 | 5 | 5 | 15 | 4 | 4 |
| Example 7 | Micromica MK-100*1 | 20 | PVA-203 | 1.50 | 100 | 5 | 5 | 15 | 5 | 4 |
| Example 8 | Micromica MK-100*1 | 40 | PVA-203 | 1.50 | 100 | 5 | 5 | 15 | 5 | 4 |
| Example 9 | SOMASIF ME-100 | 20 | KL-506*2 | 0.75 | 95 | 5 | 5 | 14 | 5 | 5 |
| Example 10 | SOMASIF ME-100 | 20 | KL-506*2 | 1.25 | 100 | 5 | 5 | 15 | 5 | 4 |
| Example 11 | SOMASIF MF-100 | 20 | KL-506*2 | 1.75 | 100 | 5 | 5 | 15 | 5 | 3 |

(continued)

| | Protective layer | | | | Results of evaluation | | | | | |
|---|---|---|---|---|---|---|---|---|---|---|
| | Inorganic layered compound | | Binder component | Whole coating amount ($g/m^2$) | Sensitivity | Image quality | Printing performance | | Bonding resistance | Soiling in the developing solution tank |
| | Type | Content (% by mass) | | | | | Stains in the non-image area | Printing durability ($10^4$ copies) | | |
| Comparative Example 1 | - | - | PVA-105 | 2.00 | 100 | 5 | 5 | 15 | 1 | 1 |
| Comparative Example 2 | - | - | KL-506*2 | 1.00 | 65 | 3 | 5 | 5 | 1 | 4 |

*1: Manufactured by Cope Chemical, aspect ratio: 20 to 30
*2: Manufactured by Kuraray Co., Ltd., degree of saponification: 77 mol%, degree of polymerization: 600

It is apparent from Table 1 that the planographic printing plate precursors of Examples 1 to 11, namely, the planographic printing plate precursors comprising a protective layer containing a mica compound and a specific polyvinyl alcohol on a polymerizable negative type photosensitive layer had high sensitivity and high image quality, were resistant to stains in the non-image area during printing and were superior in printing durability. Also, even after being subjected to highly humid conditions, the planographic printing plate precursors were not seen to adhere to each other and it was also found that even if a pre-water-washing step was omitted and development treatment was continuously carried out, the inside wall of the developing solution tank was not soiled.

On the other hand, the planographic printing plate precursor of Comparative Example 1 provided with a protective layer which did not contain both the mica compound and the specific polyvinyl alcohol was found to have the practical problem that the planographic printing plate precursors were observed to adhere to each other after being subjected to highly humid conditions, with bonding resistance being significantly deteriorated, and there was soiling on the inside wall of a developing solution tank when the pre-water-washing step was omitted and continuous development treatment was carried out. It is inferred that the generation of soiling in the developing solution tank is caused by the precipitation and coagulation of polyvinyl alcohol along with an increase in the concentration of polyvinyl alcohol dissolved in the developing solution because polyvinyl alcohol having a high degree of saponification is used and the amount of the protective layer applied is large.

Moreover, the planographic printing plate precursor of Comparative Example 2 provided with a protective layer containing a specific polyvinyl alcohol and no mica compound was found to be inferior in sensitivity, image quality, printing durability and bonding resistance when compared to each of planographic printing plate precursors obtained in Examples 1 to 11 although it was found to be excellent in resistance to stains in the non-image area and soiling in the developing tank during printing.

The invention can provide a planographic printing plate precursor which enables writing using an infrared laser, is provided with a protective layer and is capable of improving productivity in plate-making operations, and also provides a method of making the planographic printing plate precursor.

More specifically, the invention can provide a planographic printing plate precursor which enables writing using an infrared laser, prevents polymerization inhibition, has superior developing removability, and is also provided with a protective layer which improves bonding resistance of the photosensitive layer side surface (the surface of the protective layer) of a planographic printing plate precursor to the support side surface of a planographic printing plate precursor adjacent to the above planographic printing plate precursor when these planographic printing plate precursors are laminated, and also provides a method of plate-making the precursor.

## Claims

1. A planographic printing plate precursor comprising a photosensitive layer containing an infrared absorber, a polymerization initiator, a polymerizable compound and a binder polymer, and a protective layer laminated on a support in this order, wherein;
   the protective layer contains a mica compound and at least one polyvinyl alcohol selected from the group consisting of a polyvinyl alcohol having a saponification value of 90 mol% or less and an acid modified polyvinyl alcohol.

2. The planographic printing plate precursor according to Claim 1, wherein the amount of the protective layer applied is from 0.5 $g/m^2$ to 1.5 $g/m^2$.

3. The planographic printing plate precursor according to Claim 1 or 2, wherein the content of the mica compound is from 5% by mass to 55% by mass based on the total solid content of the protective layer.

4. The planographic printing plate precursor according to any one of Claims 1 to 3, wherein the binder polymer has a repeating unit represented by the following formula (i):

Formula (i)

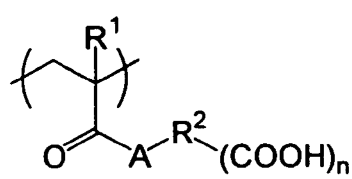

wherein $R^1$ represents a hydrogen atom or a methyl group; $R^2$ represents a linking group containing two or more atoms selected from the group consisting of a carbon atom, a hydrogen atom, an oxygen atom, a nitrogen atom and a sulfur atom, and the total number of atoms in $R^2$ is 2 to 82; A represents an oxygen atom or $-NR^3-$ in which $R^3$ represents a hydrogen atom or a monovalent hydrocarbon group having 1 to 10 carbon atoms; and n denotes an integer from 1 to 5.

**5.** The planographic printing plate precursor according to any one of Claims 1 to 4, wherein the mica compound has an aspect ratio of 20 or more.

**6.** The planographic printing plate precursor according to any one of Claims 1 to 5, wherein the photosensitive layer further contains a dye or a pigment as a colorant.

**7.** A method of making a planographic printing plate, the method comprising exposing the planographic printing plate precursor as claimed in any one of Claims 1 to 6 to light having a wavelength of 750 nm to 1400 nm and then carrying out development treatment at a conveying speed of 1.25 m/min. or more with substantially no heat treatment and no water-washing treatment.

**8.** The planographic printing plate precursor according to any one of Claims to 6, wherein the infrared absorber is represented by the following formula (a):

Formula (a)

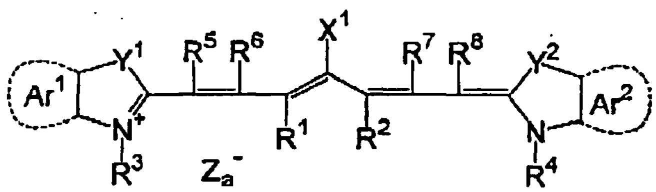

wherein $X^1$ represents a hydrogen atom, a halogen atom, $-NPh_2$, $X^2-L^1$ or a group represented by the following structural formula ; $X^2$ represents an oxygen atom, a nitrogen atom or a sulfur atom; $L^1$ represents a hydrocarbon group having 1 to 12 carbon atoms, an aromatic ring having a heteroatom, or a hydrocarbon group having 1 to 12 carbon atoms containing a heteroatom that is N, S, O, a halogen atom or Se; $R^1$ and $R^2$ independently represent a hydrocarbon group having 1 to 12 carbon atoms; $Ar^1$ and may be the same or different and each represent an aromatic hydrocarbon group which may have a substituent group; $Y^1$ and $Y^2$ may be the same or different and each represent a sulfur atom or a dialkyl methylene group having 12 or less carbon atoms; $R^3$ and $R^4$ may be the same or different and each represent a hydrocarbon group having 20 or less carbon atoms, which may have a substituent group; $R^5$, $R^6$, $R^7$ and $R^8$ may be the same or different and each represent a hydrogen atom or a hydrocarbon group having 12 or less carbon atoms; $Za^-$ represents a counter anion present except when the infrared absorber represented by the formula (a) has an anionic substituent group in its structure and does not necessitate neutralization of the charge;

Structural formula

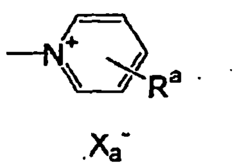

wherein $Xa^-$ has the same meaning as that of $Za^-$; and $R^3$ represents a substituent group selected from a hydrogen atom, an alkyl group, an aryl group, a substituted or unsubstituted amino group, and a halogen atom.

**9.** The planographic printing plate precursor according to any one of Claims 1 to 6, wherein the at least one polyvinyl

alcohol contained in the protective layer is an acid modified polyvinyl alcohol.

**Patentansprüche**

1. Planographie-Druckplattenvorläufer umfassend eine fotoempfindliche Schicht, die einen Infrarotabsorber, einen Polymerisationsstarter, eine polymerisierbare Verbindung und-ein Bindemittelpolymer enthält, und eine Schutzschicht, die in dieser Reihenfolge auf einen Träger laminiert sind, wobei
die Schutzschicht eine Glimmerverbindung und wenigstens einen Polyvinylalkohol ausgewählt aus der Gruppe bestehend aus einem Polyvinylalkohol mit einer Verseifungszahl von 90 mol% oder weniger und einem säuremodifizierten Polyvinylalkohol enthält.

2. Planographie-Druckplattenvorläufer gemäß Anspruch 1, wobei die aufgetragene Menge der Schutzschicht 0,5 $g/m^2$ bis 1,5 $g/m^2$ beträgt.

3. Planographie-Druckplattenvorläufer gemäß Anspruch 1 oder 2, wobei der Gehalt der Glimmerverbindung von 5 Massen% bis 55 Massen%, bezogen auf den Gesamtfeststoffgehalt der Schutzschicht, beträgt.

4. Planographie-Druckplattenvorläufer gemäß einem der Ansprüche 1 bis 3, wobei das Bindemittelpolymer eine sich wiederholende Einheit aufweist, die durch die folgende Formel (i) dargestellt wird:

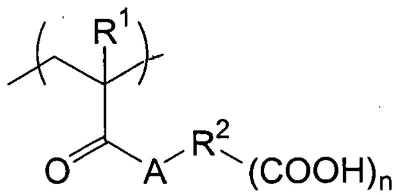

(i)

wobei $R^1$ ein Wasserstoffatom oder eine Methylgruppe darstellt, $R^2$ eine Verbindungsgruppe darstellt, die zwei oder mehr Atome ausgewählt aus der Gruppe bestehend aus einem Kohlenstoffatom, einem Wasserstoffatom, einem Sauerstoffatom, einem Stickstoffatom und einem Schwefelatom enthält und die Gesamtanzahl der Atome in $R^2$ 2 bis 82 beträgt, A ein Sauerstoffatom oder $-NR^3-$ darstellt, wobei $R^3$ ein Wasserstoffatom oder eine einwertige Kohlenwasserstoffgruppe mit 1 bis 10 Kohlenstoffatomen darstellt, und n eine ganze Zahl von 1 bis 5 darstellt.

5. Planographie-Druckplattenvorläufer gemäß einem der Ansprüche 1 bis 4, wobei die Glimmerverbindung ein Seitenverhältnis von 20 oder mehr aufweist.

6. Planographie-Druckplattenvorläufer gemäß einem der Ansprüche 1 bis 5, wobei die fotoempfindliche Schicht ferner einen Farbstoff oder ein Pigment als farbgebende Substanz enthält.

7. Verfahren zum Herstellen einer Planographie-Druckplatte umfassend Belichten des Planographie-Druckplattenvorläufers, wie in einem der Ansprüche 1 bis 6 beansprucht, mit Licht einer Wellenlänge von 750 bis 1.400 nm und anschließendem Durchführen einer Entwicklungsbehandlung bei einer Fördergeschwindigkeit von 1,25 m/min oder mehr im wesentlichen ohne Wärmebehandlung und ohne Wasserwaschbehandlung.

8. Planographie-Druckplattenvorläufer gemäß einem der Ansprüche 1 bis 6, wobei der Infrarotabsorber durch die folgende Formel (a) dargestellt wird:

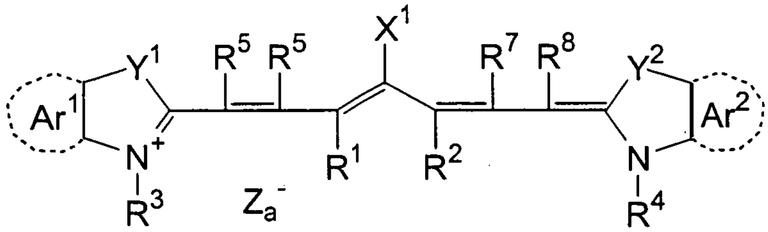

(a)

wobei $X^1$ ein Wasserstoffatom, ein Halogenatom, $-NPh_2$, $X^2$-$L^1$ oder eine durch die folgende Strukturformel dargestellte Gruppe darstellt, $X^2$ ein Sauerstoffatom, ein Stickstoffatom oder ein Schwefelatom darstellt, $L^1$ eine Kohlenwasserstoffgruppe mit 1 bis 12 Kohlenstoffatomen darstellt, einen aromatischen Ring mit einem Heteroatom oder eine Kohlenwasserstoffgruppe mit 1 bis 12 Kohlenstoffatomen enthaltend ein Heteroatom, das N, S, O, ein Halogenatom oder Se ist, $R^1$ und $R^2$ unabhängig voneinander eine Kohlenwasserstoffgruppe mit 1 bis 12 Kohlenstoffatomen darstellen, $Ar^1$ und $Ar^2$ gleich oder verschieden sein können und jeweils eine aromatische Kohlenwasserstoffgruppe darstellen, die eine Substituentengruppe aufweisen kann, $Y^1$ und $Y^2$ gleich oder verschieden sein können und jeweils ein Schwefelatom oder eine Dialkylmethylengruppe mit 12 oder weniger Kohlenstoffatomen darstellen, $R^3$ und $R^4$ gleich oder verschieden sein können und jeweils eine Kohlenwasserstoffgruppe mit 20 oder weniger Kohlenstoffatomen darstellen, die eine Substituentengruppe aufweisen können, $R^5$, $R^6$, $R^7$ und $R^8$ gleich oder verschieden sein können und jeweils ein Wasserstoffatom oder eine Kohlenwasserstoffgruppe mit 12 oder weniger Kohlenstoffatomen darstellen, $Za^-$ ein Gegenanion darstellt, außer wenn der durch die Formel (a) dargestellte Infrarotabsorber eine anionische Substituentengruppe in seiner Struktur aufweist und keine Ladungsneutralisation notwendig ist,

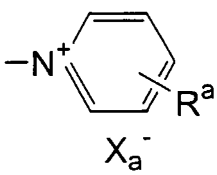

wobei $Xa^-$ die gleiche Bedeutung wie $Za^-$ hat und $R^a$ eine Substituentengruppe darstellt, die aus einem Wasserstoffatom, einer Alkylgruppe, einer Arylgruppe, einer substituierten oder unsubstituierten Aminogruppe und einem Halogenatom ausgewählt ist.

9. Planographie-Druckplattenvorläufer gemäß einem der Ansprüche 1 bis 6, wobei der in der Schutzschicht enthaltene wenigstens eine Polyvinylalkohol ein säuremodifizierter Polyvinylalkohol ist.

**Revendications**

1. Précurseur de plaque d'impression planographique comprenant une couche photosensible contenant un absorbeur d'infrarouge, un amorceur de polymérisation, un composé polymérisable et un polymère de liaison, et une couche protectrice laminée sur un support dans cet ordre,
dans lequel :

   la couche protectrice contient un composé de mica et au moins un alcool polyvinylique sélectionné dans le groupe constitué par un alcool polyvinylique ayant un indice de saponification de 90 % en moles ou moins et un alcool polyvinylique modifié par un acide.

2. Précurseur de plaque d'impression planographique selon la revendication 1, dans lequel la quantité de couche protectrice appliquée est de 0,5 g/$m^2$ à 1,5 g/$m^2$.

3. Précurseur de plaque d'impression planographique selon la revendication 1 ou 2, dans lequel la teneur en composé de mica est de 5 % en masse à 55 % en masse en se basant sur la teneur totale en solide de la couche protectrice.

4. Précurseur de plaque d'impression planographique selon l'une quelconque des revendications 1 à 3, dans lequel le polymère de liaison a une unité répétitive représentée par la formule (i) suivante :

Formule (i)

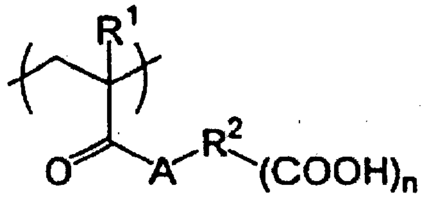

dans laquelle $R^1$ représente un atome d'hydrogène ou un groupe méthyle ; $R^2$ représente un groupe de liaison contenant deux ou plusieurs atomes selectionnés dans le groupe constitué par un atome de carbone, un atome d'hydrogène, un atome d'oxygène, un atome d'azote et un atome de soufre, et le nombre total d'atomes dans $R^2$ est de 2 à 82 ; A représente un atome d'oxygène ou $-NR^3-$ dans lequel $R^3$ représente un atome d'hydrogène ou un groupe hydrocarboné monovalent ayant 1 à 10 atomes de carbone ; et n représente un nombre entier de 1 à 5.

5. Précurseur de plaque d'impression planographique selon l'une quelconque des revendications 1 à 4, dans lequel le composé de mica a un rapport dimensionnel de 20 ou davantage.

6. Précurseur de plaque d'impression planographique selon l'une quelconque des revendications 1 à 5, dans lequel la couche photosensible contient en outre un colorant ou un pigment en tant que colorant.

7. Procédé de fabrication d'une plaque d'impression planographique, le procédé comprenant l'exposition du précurseur de plaque d'impression planographique tel que revendiqué dans l'une quelconque des revendications 1 à 6 à une lumière ayant une longueur d'onde de 750 nm à 1400 nm, et ensuite mise en oeuvre d'un traitement de développement à une vitesse de transport de 1,25 m/min. ou davantage substantiellement sans traitement thermique ni traitement de lavage à l'eau.

8. Précurseur de plaque d'impression planographique selon l'une quelconque des revendications 1 à 6, dans lequel l'absorbeur d'infrarouge est représenté par la formule (a) suivante :

Formule (a)

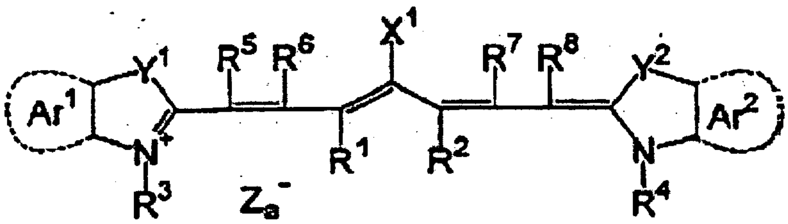

dans laquelle $X^1$ représente un atome d'hydrogène, un atome d'halogène, $-NPh_2$, $X^2-L^1$ ou un groupe représenté par la formule structurelle suivante ; $X^2$ représente un atome d'oxygène, un atome d'azote ou un atome de soufre ; $L^1$ représente un groupe hydrocarboné ayant 1 à 12 atomes de carbone, un cycle aromatique ayant un hétéroatome, ou un groupe hydrocarboné ayant 1 à 12 atomes de carbone contenant un hétéroatome qui est N, S, O, un atome d'halogène ou Se ; $R^1$ et $R^2$ représentent indépendamment un groupe hydrocarboné ayant 1 à 12 atomes de carbone ; $Ar^1$ et $Ar^2$ peuvent être les mêmes ou différents et chacun représente un groupe hydrocarboné aromatique qui peut avoir un groupe substituant; $Y^1$ et $Y^2$ peuvent être les mêmes ou différents et chacun représente un atome de soufre ou un groupe méthylène dialkyle ayant 12 atomes de carbone ou moins ; $R^3$ et $R^4$ peuvent être les mêmes ou différents et chacun représente un groupe hydrocarboné ayant 20 atomes de carbone ou moins, qui peut avoir

un groupe substituant ; $R^5$, $R^6$, $R^7$ et $R^8$ peuvent être les mêmes ou différents et chacun représente un atome d'hydrogène ou un groupe hydrocarboné ayant 12 atomes de carbone ou moins ; $Za^-$ représente un contre-anion présent excepté lorsque l'absorbeur d'infrarouge représenté par la formule (a) a un groupe substituant anionique dans sa structure et ne nécessite pas de neutralisation de la charge;

Formule structurelle

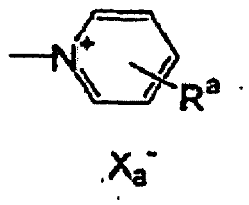

dans laquelle $Xa^-$ a la même signification que celle de $Za^-$; et $R^a$ représente un groupe substituant sélectionné parmi un atome d'hydrogène, un groupe alkyle, un groupe aryle, un groupe amino substitué ou non substitué, et un atome d'halogène.

9. Précurseur de plaque d'impression planographique selon l'une quelconque des revendications 1 à 6, dans lequel le au moins un alcool polyvinylique contenu dans la couche protectrice est un alcool polyvinylique modifié par un acide.

FIG.1

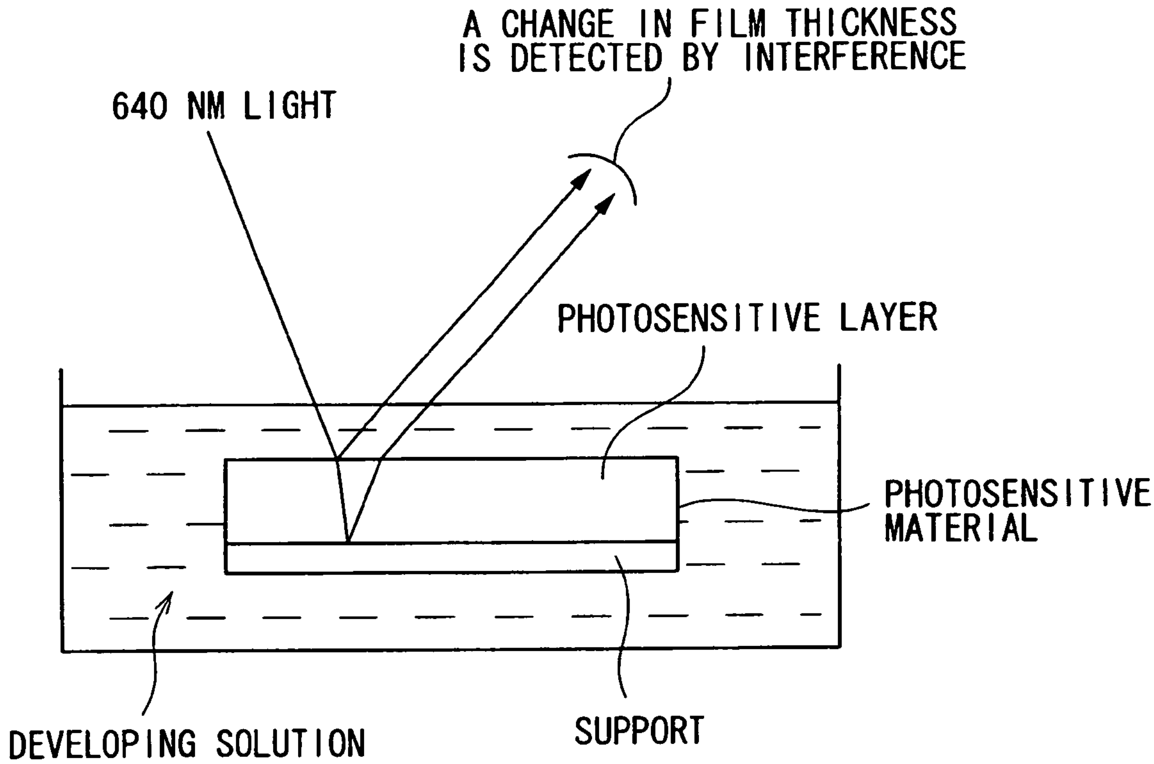
A CHANGE IN FILM THICKNESS
IS DETECTED BY INTERFERENCE
640 NM LIGHT
PHOTOSENSITIVE LAYER
PHOTOSENSITIVE
MATERIAL
DEVELOPING SOLUTION
SUPPORT

FIG.2

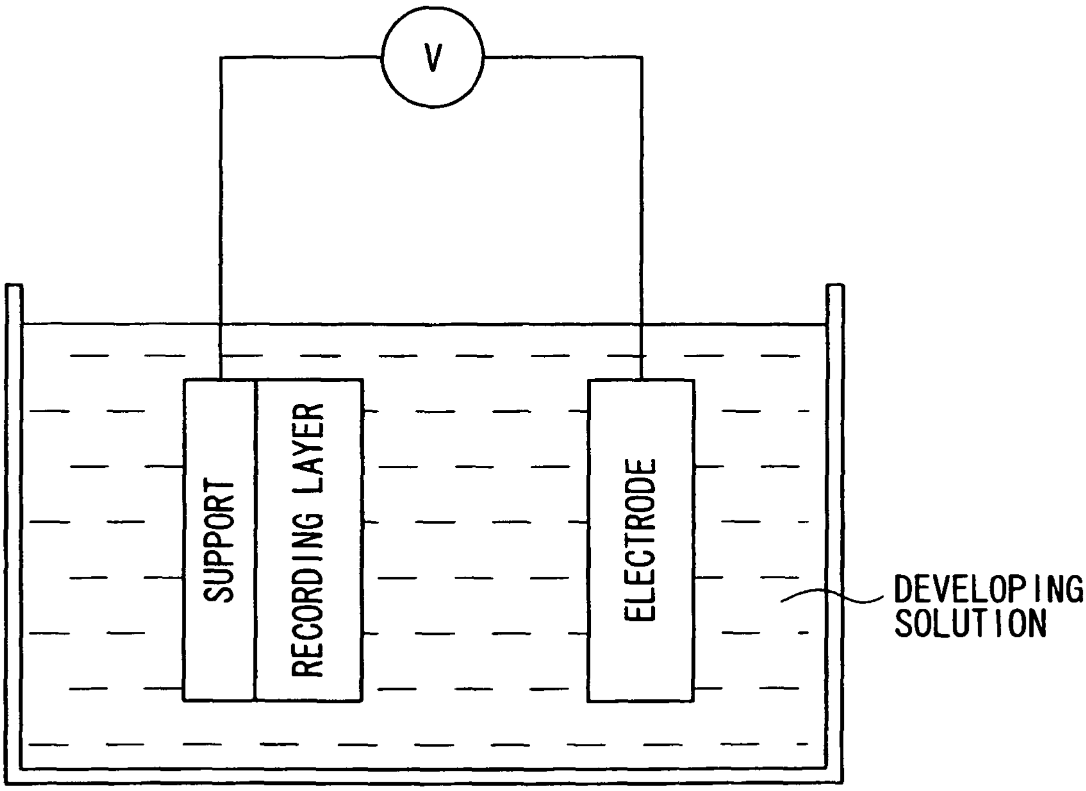

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 10228109 A
- JP 7103171 B
- JP 11038633 A
- JP 2004118070 A
- EP 1176467 A1
- US 292501 A
- US 44563 A
- US 3458311 A
- JP 55049729 A
- JP 58125246 A
- JP 59084356 A
- JP 59202829 A
- JP 60078787 A
- JP 58173696 A
- JP 58181690 A
- JP 58194595 A
- JP 58112793 A
- JP 58224793 A
- JP 59048187 A
- JP 59073996 A
- JP 60052940 A
- JP 60063744 A
- JP 58112792 A
- US 434875 A
- US 5156938 A
- US 3881924 A
- JP 57142645 A
- US 4327169 A
- JP 58181051 A
- JP 58220143 A
- JP 59041363 A
- JP 59084248 A
- JP 59084249 A
- JP 59146063 A
- JP 59146061 A
- JP 59216146 A
- US 4283475 A
- JP 5013514 B
- JP 5019702 B
- US 4756993 A
- JP 2001006326 A
- JP 2001237840 A
- JP 2001133969 A
- JP 2002148790 A
- JP 2002350207 A
- JP 2002006482 A
- JP 2001133696 A
- JP 46027926 B
- JP 51047334 B
- JP 57196231 A
- JP 59005240 A
- JP 59005241 A
- JP 2226149 A
- JP 1165613 A
- JP 54021726 B
- JP 48041708 B
- JP 51037193 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 48064183 A
- JP 49043191 B
- JP 52030490 B
- JP 46043946 B
- JP 1040337 B
- JP 1040336 B
- JP 2025493 A
- JP 61022048 A
- JP 48018327 B
- JP 56028893 A
- JP 53012739 A
- JP 48028123 B
- US 3658662 A
- JP 46027481 B
- JP 52058602 A
- JP 52030503 A
- JP 50007481 B
- JP 54072104 A
- JP 59101651 A
- JP 60149491 A
- JP 60232998 A
- JP 3056177 A
- JP 4282637 A
- JP 5016558 A
- JP 5246171 A
- JP 7159983 A
- JP 7314937 A
- JP 8202025 A
- JP 8320551 A
- JP 9034104 A
- JP 9236911 A
- JP 9269593 A

- JP 10069092 A
- JP 10115931 A
- JP 10161317 A
- JP 10260536 A
- JP 10282682 A
- JP 11084674 A
- JP 11038635 A
- JP 11038629 A
- JP 10282465 A
- JP 10301262 A
- JP 11024277 A
- JP 11109641 A
- JP 10319600 A
- JP 11327152 A
- JP 2000010292 A
- JP 2000235254 A
- JP 2000352824 A
- JP 2001209170 A
- US 4882246 A
- JP 50026601 A
- JP 58054341 A
- JP 56039464 B
- JP 56042860 B
- JP 57007427 B

**Non-patent literature cited in the description**

- Saishin Ganryo Binran. the Japanese Society of Pigment Technology, 1977
- Saishin Ganryho Oyo Gijyutsu. CMC Publishing Co., Ltd, 1986
- Insatsu Inki Gijyutsu. CMC Publishing Co., Ltd, 1984
- Kinzoku Sekken No Seishitsu To Oyo. Sachi Shobo
- *the Journal of Japanese Adhesive Society,* 1984, vol. 20 (7), 300-308
- Polymer Data Handbook -Fundamental Version-. the Society of Polymer Science. Baifukan, 1986